(19) **Europäisches Patentamt / European Patent Office / Office européen des brevets**

(11) **EP 3 956 634 B1**

(12) **FASCICULE DE BREVET EUROPEEN**

(45) Date de publication et mention de la délivrance du brevet:
**25.03.2026 Bulletin 2026/13**

(21) Numéro de dépôt: **20716850.1**

(22) Date de dépôt: **14.04.2020**

(51) Classification Internationale des Brevets (IPC):
*G01C 19/72* (2006.01) *G01R 15/24* (2006.01)

(52) Classification Coopérative des Brevets (CPC):
**G01C 19/727;** G01R 15/246

(86) Numéro de dépôt international:
**PCT/EP2020/060408**

(87) Numéro de publication internationale:
**WO 2020/212314 (22.10.2020 Gazette 2020/43)**

(54) **INTERFÉROMÈTRE À FIBRE OPTIQUE EN BOUCLE OU EN LIGNE**

INTERFEROMETER MIT EINER SCHLEIFENFÖRMIGEN ODER GERADEN OPTISCHEN FASER

INTERFEROMETER WITH A LOOPED OR STRAIGHT OPTICAL FIBRE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.04.2019 FR 1904009**

(43) Date de publication de la demande:
**23.02.2022 Bulletin 2022/08**

(73) Titulaire: **EXAIL**
**78100 Saint-Germain-en-Laye (FR)**

(72) Inventeurs:
• **DUCLOUX, Eric**
**78100 SAINT-GERMAIN-EN-LAYE (FR)**
• **MOLUCON, Cédric**
**78100 SAINT GERMAIN EN LAYE (FR)**
• **LEFEVRE, Hervé**
**78100 SAINT-GERMAIN-EN-LAYE (FR)**

(74) Mandataire: **Jacobacci Coralis Harle**
**32, rue de l'Arcade**
**75008 Paris (FR)**

(56) Documents cités:
EP-B1- 2 005 113          WO-A1-2013/160622
WO-A1-2017/220922      FR-A1- 2 654 827

## Description

### Domaine technique

La présente invention concerne de manière générale le domaine des systèmes interférométriques.

Elle concerne plus particulièrement un système interférométrique à fibre optique en boucle ou bien en ligne. Un tel système interférométrique trouve notamment des applications dans les gyroscopes à fibre optique (ou FOG pour fiber-optic gyroscope, voir « The Fiber-Optic Gyroscope », H. C. Lefèvre, Artech House, Second Edition, 2014). Un tel système interférométrique trouve aussi des applications dans les capteurs de courant électrique (ou FOCS pour fiber-optic current sensor) ou encore les capteurs de champ magnétique.

Elle concerne en particulier un système et procédé interférométrique à fibre optique de grande précision.

### Technique antérieure

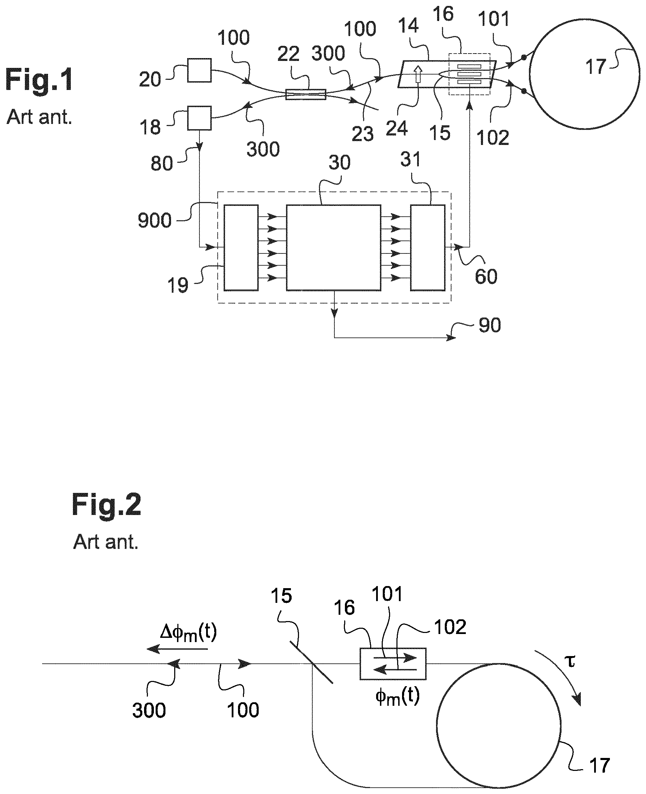

La figure 1 représente schématiquement un système interférométrique à fibre optique en boucle de Sagnac selon l'art antérieur. Ce système interférométrique à fibre optique comporte une source de lumière 20 émettant un faisceau source 100, un séparateur source-récepteur 22, dit séparateur de récepteur, un circuit optique intégré multifonction 14 (noté MIOC pour Multifunction Integrated Optical Circuit en terminologie anglo-saxonne), une bobine de fibre optique 17, un photodétecteur 18 et un système de traitement du signal 900. Le circuit optique intégré 14 comprend des guides d'onde optiques formés de préférence par échange protonique (ou APE pour Annealed Proton Exchange) sur un substrat plan électro-optique, par exemple de niobate de lithium. L'échange protonique sur niobate de lithium conduit à la formation de guides mono-polarisation. Le guide d'onde d'entrée-sortie forme donc un polariseur 24 à guide d'onde monomode qui ne guide qu'une seule polarisation linéaire. Le circuit optique intégré 14 comprend aussi un séparateur de bobine 15 de type à jonction Y formé par division du guide d'onde d'entrée-sortie en deux branches secondaires monomodes. De façon avantageuse, le circuit optique intégré 14 comprend aussi des électrodes reliées à un générateur électrique pour former un modulateur électro-optique ou modulateur de phase 16 adapté pour moduler la différence de phase $\Delta\Phi$ entre deux faisceaux contra-propagatifs. Le substrat plan du circuit optique intégré multifonction 14 peut aisément être relié sur un côté aux deux extrémités de la bobine de fibre optique 17 et sur un côté opposé par une section de fibre optique 23 au séparateur source-récepteur 22.

Le séparateur de bobine 15 sépare spatialement le faisceau source 100 en une première onde monomode 101 et une seconde onde monomode 102, qui se propagent dans des directions opposées dans la bobine de fibre optique 17. En sortie de la bobine, le séparateur de bobine 15 recombine ces deux ondes monomodes pour former un faisceau interférométrique 300. Le séparateur source-récepteur 22 guide le faisceau interférométrique 300 vers le photodétecteur 18. Le détecteur 18 reçoit le faisceau interférométrique et génère un signal détecté 80.

Le système de traitement du signal 900 comprend par exemple un convertisseur analogique-numérique 19, un processeur numérique 30, par exemple de type DSP (Digital Signal Processor), FPGA (Field Programmable Gate Array) ou ASIC (Application Specific Integrated Circuit), et un convertisseur numérique-analogique 31. Le processeur numérique 30 permet d'extraire un signal d'un paramètre à mesurer 90, par exemple de vitesse de rotation, sur une sortie numérique. Le convertisseur numérique-analogique 31 permet d'appliquer une tension de modulation 60 sur les électrodes du modulateur optique de phase 16.

Lorsque le système interférométrique est au repos, les deux faisceaux divisés émergent de la bobine de fibre optique en phase, du fait de la réciprocité des trajets optiques dans la bobine de fibre optique.

Toutefois, en présence de phénomènes physiques susceptibles de produire des effets non-réciproques sur le trajet optique des deux faisceaux contra-propagatifs dans la bobine de fibre optique 7, une différence de phase apparaît dans le faisceau interférométrique détecté. La réponse en boucle ouverte d'un système interférométrique tel que décrit ci-dessus est une fonction de la différence de phase $\Delta\Phi$ liée à la grandeur à mesurer selon l'équation suivante, où P est la puissance du faisceau interférométrique retour 300, $P_0$ étant elle la puissance maximum retour quand $\Delta\Phi=0$.

$$[Math\ 1]$$

$$P = \frac{P_0}{2}(1 + cos\,\Delta\Phi)$$

Parmi les principaux phénomènes physiques induisant des effets non-réciproques, la rotation du système interférométrique autour de l'axe de la bobine de fibre optique induit une différence de phase proportionnelle à la vitesse de rotation. De cette propriété, appelée effet Sagnac, découle la principale application d'un interféromètre en boucle de Sagnac à un gyroscope pour mesurer une vitesse de rotation autour de l'axe de la bobine de fibre optique. En effet, lors d'une rotation de l'interféromètre autour de l'axe de la bobine de fibre optique 17, une différence de phase $\Delta\Phi_s$ est induite par le paramètre à mesurer. En présence d'effet Sagnac dans un FOG, la différence de phase $\Delta\Phi_s$ est proportionnelle à la vitesse de rotation.

L'effet Faraday ou effet magnéto-optique colinéaire est aussi connu pour produire des effets non-réciproques. Les interféromètres à fibre optique en boucle ou en ligne ont des applications comme capteur de champ magnétique ou comme capteur de courant électrique (voir la publication J. Blake et al. « In-Line Sagnac Interferometer Current Sensor » IEEE Transactions on Power Delivery, Vol. 11, n° 1, pages 116-121, 1996).

Un interféromètre de Sagnac conventionnel, dit en boucle, utilise un chemin optique refermé, le même composant optique séparateur 15 séparant les deux ondes et les recombinant, les deux ondes séparées parcourant le chemin optique refermé en sens mutuellement opposés. Dans un interféromètre à fibre optique en boucle, les deux ondes séparées utilisent le même état de polarisation sur le chemin optique refermé. Dans un gyromètre à fibre optique en boucle, les deux ondes ont la même polarisation linéaire. Dans un capteur de courant en boucle, les deux ondes ont la même polarisation circulaire dans la boucle de fibre optique. Dans un interféromètre à fibre optique en ligne, un miroir est disposé à une extrémité de la bobine de fibre optique, et le chemin optique refermé est parcouru par les deux ondes dans le même sens et suivant des états orthogonaux de polarisation qui s'inversent au retour (voir la publication G.M. Muller et al. « Inherent temperature compensation of fiber-optic current sensors employing spun highly birefringent fiber", Optics Express, Vol. 24, No 10, 2016).

Par rapport à un système en boucle, un tel système interférométrique à fibre optique en ligne est insensible aux variations de nombreux paramètres environnementaux mais fonctionne de façon équivalente pour la question de la modulation de phase.

Les techniques de modulation de phase, bien connues de l'homme du métier dans les interféromètres à fibre optique, sont utilisées pour améliorer la sensibilité et la linéarité de la réponse de l'interféromètre à une différence de phase due à un effet non réciproque, par exemple l'effet Sagnac ou l'effet Faraday magnéto-optique colinéaire. Dans le présent document, on entend par grandeur à mesurer une différence de phase induite par un effet non-réciproque dans un interféromètre à fibre optique en boucle ou en ligne.

La figure 2 représente un modulateur de phase 16 dans un interféromètre à fibre optique en boucle de l'art antérieur.

Dans le domaine ci-dessus, il est connu d'appliquer une tension électrique modulée $V_m(t)$ entre les électrodes du modulateur de phase 16 pour moduler la différence de phase $\Delta\Phi_m(t)$ du signal interférométrique mesuré. Cette modulation permet une mise au biais qui augmente la sensibilité du système interférométrique, notamment pour des mesures de rotation de faible amplitude. Plus précisément, le modulateur de phase 16 génère un déphasage $\Phi_m(t)$ qui est réciproque, c'est-à-dire parfaitement identique dans les deux sens de propagation. Toutefois, il existe une différence de temps de propagation, notée $\Delta\tau$, entre le chemin optique le plus long qui passe par la bobine de fibre optique 17 et le chemin optique le plus court qui ressort directement vers le séparateur-combineur 15. Cette différence de temps de propagation $\Delta\tau$ est liée à la vitesse de groupe $v_g$ des ondes et non à leur vitesse de phase $v_\Phi$. On obtient ainsi une modulation de la différence de phase $\Delta\Phi_m(t)$ selon l'équation suivante.

[Math 2]

$$\Delta\Phi_m(t) = \Phi_m(t) - \Phi_m(t - \Delta\tau)$$

Cette modulation du déphasage $\Phi_m(t)$ est obtenue en appliquant une tension électrique modulée $V_m(t)$ 60 sur les électrodes du modulateur de phase 16.

Il est aussi possible d'avoir un deuxième modulateur placé à l'autre extrémité de la bobine et de le connecter électriquement en inverse pour doubler l'efficacité de modulation dans une configuration dite push-pull. Le circuit 14 de la figure 1 utilise un tel montage push-pull pour le modulateur 16 qui est placé sur les deux branches de la jonction Y.

En particulier, il est connu d'appliquer une modulation dite 2-états, en modulant la tension de modulation $V_m$ en carré entre deux valeurs de paliers, de manière à produire une modulation de la différence de phase sur deux niveaux, par exemple de $\Delta\Phi_b(t) = \pm\,\pi/2$, dite différence de phase de mise au biais, à la fréquence propre $f_p$ de la bobine de fibre optique. La fréquence propre $f_p$ est définie de telle manière que $T/2 = 1/(2.f_p) = \Delta\tau$ où T représente la période de la modulation carrée. Ainsi, la demi-période de modulation T/2 correspond à la différence de temps de propagation de groupe $\Delta\tau$ entre le chemin optique long passant par la bobine et le chemin optique court qui relie le modulateur de phase 16 au séparateur 15. Le système de détection acquiert la puissance du faisceau interférométrique en sortie de l'interféromètre suivant les deux états de modulation. Le système de traitement du signal numérise le faisceau interférométrique détecté et démodule à $f_p$ le signal détecté en échantillonnant deux mesures de puissance sur chaque période de modulation et en affectant un signe négatif à un premier niveau et un signe positif au niveau suivant. Ce schéma de modulation-démodulation basé sur une tension de modulation carrée générant 2 états à la fréquence $f_p$ permet d'obtenir une meilleure sensibilité du système interférométrique et une meilleure stabilité des mesures autour de zéro, indépendamment des variations de la puissance de sortie. Il est à noter qu'on observe des pics entre les mesures successives du signal détecté.

Il est aussi connu d'appliquer une modulation carrée à 2 états avec une modulation de la différence de phase $\Delta\Phi_m$ (t) supérieure à $\pm \pi/2$, comme par exemple $\pm 3\pi/4$ ou $\pm 7\pi/8$. Cette surmodulation diminue la sensibilité mais améliore le rapport signal à bruit du système interférométrique.

Afin d'étendre et de linéariser la dynamique de réponse d'un système interférométrique, il est aussi connu d'appliquer un signal de contre-réaction. Le signal démodulé est utilisé comme signal d'erreur dans une boucle d'asservissement pour générer une différence de phase supplémentaire $\Delta\Phi_{FB}$ qui s'oppose à la différence de phase $\Delta\Phi_S$ de la grandeur à mesurer. La différence de phase totale $\Delta\Phi_{FS} + \Delta\Phi_S$ est asservie à zéro et $-\Delta\Phi_{FB}$, qui est égale à $\Delta\Phi_S$, devient la mesure, ce qui permet d'obtenir une réponse linéaire et une bonne stabilité de celle-ci, indépendamment des variations de puissance ou du gain du système de détection.

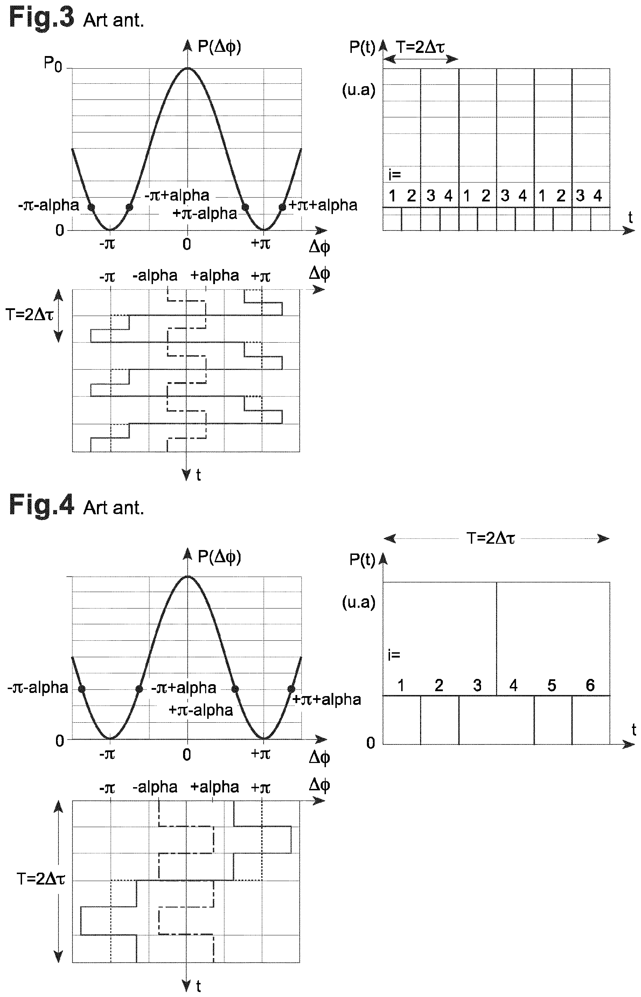

Dans le domaine ci-dessus, le brevet FR2654827_A1 propose d'appliquer une tension de modulation dite 4-états qui génère 4 niveaux successifs de $\Delta\Phi_m$(t) sur chaque période de modulation T égale à $2\Delta\tau$. La figure 3 illustre un exemple de modulation à 4 états. Sur la figure 3, on a représenté respectivement : en bas à gauche, la modulation de la différence de phase $\Delta\Phi$ en fonction du temps t ; en haut à gauche, la puissance P du faisceau interférométrique en fonction de la différence de phase $\Delta\Phi$ ; et, en haut à droite, la puissance P du faisceau interférométrique en fonction du temps. Sur une période de modulation égale à $2\Delta\tau$, les 4 états i=1, 2, 3, 4 correspondent aux 4 niveaux successifs de $\Delta\Phi_m$(t) respectivement : i=1 pour $\pi$ - alpha ; 2 pour $\pi$ + alpha ; 3 pour $-\pi$ + alpha ; 4 pour $-\pi$ - alpha. Dans l'exemple illustré sur la figure 3, pour alpha = $\pi/4$, les 4 niveaux de $\Delta\Phi_m$(t) sont les suivants : $3\pi/4$, $5\pi/4$, $-3\pi/4$, $-5\pi/4$. Cette modulation se décompose en une superposition d'une première modulation de $\pm\pi$ à la fréquence propre $f_p$ (représentée en trait pointillé sur la figure 3 en bas à gauche) et d'une seconde modulation de $\pm\pi/4$ en quadrature (représentée en tirets sur la figure 3 en bas à gauche). La modulation résultant de la superposition de la première modulation de $\pm\pi$ et de la seconde modulation de $\pm\pi/4$ est représentée en trait continu sur la figure 3 en bas à gauche. Cette modulation $\Delta\Phi_m$(t) présente quatre niveaux par période de modulation. En pratique, ceci peut être obtenu lorsque le modulateur de phase génère une modulation du déphasage $\Phi_m$(t) de $\pm\pi/2$ à la fréquence propre $f_p$ et de $\pm\pi/8$ en quadrature. Une rampe de phase numérique de contre-réaction peut être ajoutée. Les marches de durée $\Delta\tau$ de cette rampe numérique sont égales à $\Delta\Phi_{FS}$ et compensent la différence de phase signal $\Delta\Phi_S$. Les quatre états correspondant aux quatre niveaux de modulation sont représentés par des points sur la courbe P en fonction de la différence de phase $\Delta\Phi$. Sur la figure 3 en haut à droite, est représentée la puissance détectée P(t) en fonction du temps. On échantillonne 4 mesures de puissance sur chaque période de modulation. Autrement dit, on note $P_i$ la mesure de puissance détectée par le détecteur recevant le faisceau interférométrique correspondant aux quatre états i = 1,..., 4 sur une période de modulation. Pour extraire le signal de la grandeur à mesurer, le système de traitement du signal démodule le signal de puissance détecté sur 4 états en multipliant par +1 les deux états correspondant à + alpha et en multipliant par -1 les deux états correspondant à - alpha, indépendamment du signe du $\pm\pi$ de ces états. Le signal de la grandeur à mesurer est ici aussi démodulé à la fréquence propre $f_p$. Dans la modulation 4-états, le signal de la grandeur à mesurer, par exemple le signal Sagnac, présente une modulation carrée à la fréquence propre $f_p$ et est en phase avec la modulation à $\pm$ alpha et en quadrature de phase avec la modulation à $\pm \pi$. Dans la modulation 4-états, la différence de phase signal $\Delta\Phi_S$ de la grandeur à mesurer est calculée à partir du signal $S_S$ selon l'expression suivante, où les mesures $P_i$ de puissance pour les états i=1, ..., 4 sont acquises sur une période de modulation T égale à $2\Delta\tau$.

[Math 3]

$$S_S = -P_1 + P_2 + P_3 - P_4$$

Dans la modulation 4-états, il est aussi possible d'extraire un signal, dit $V_\pi$, modulé à $2f_p$. Le signal $V_\pi$ représente la fonction de transfert du modulateur de phase, c'est-à-dire le rapport entre la tension appliquée $V_m$ au modulateur et le déphasage $\Phi_m$ induit, avec $V_\pi/\pi = V_m/\Phi_m$. Or ce signal $V_n$ fluctue avec l'environnement, par exemple avec la température. La démodulation du signal $V_\pi$ s'obtient en multipliant les mesures $P_i$ de puissance échantillonnées sur chaque état par le signe du produit des signes des modulations $\pm \pi$ et $\pm$ alpha. Autrement dit, le signe + est appliqué pour les mesures correspondant aux états $+ \pi$ + alpha et $- \pi$ - alpha, et le signe - est appliqué pour les mesures correspondant aux états $+ \pi$ - alpha et $- \pi$ + alpha. La modulation 4-états permet d'asservir simultanément à zéro la différence de phase et d'asservir le réglage du signal $V_\pi$. Dans la modulation 4-états, le signal d'erreur de la fonction de transfert du modulateur, donc du $V_\pi$, est calculé selon l'expression suivante.

[Math 4]

$$S_{V_\pi} = -P_1 + P_2 - P_3 + P_4$$

Dans le domaine des systèmes interférométriques à fibre optique, le brevet EP2005113_B1 décrit une modulation dite 6-états, basée sur 4 niveaux de différence de phase de mise au biais. La figure 4 illustre un exemple de modulation à 6 états modulée à $3f_p$. Sur la figure 4, on a représenté respectivement : en bas à gauche, la modulation de la différence de phase $\Delta\Phi$ en fonction du temps t ; en haut à gauche, la puissance P du faisceau interférométrique en fonction de la différence de phase $\Delta\Phi$ ; et, en haut à droite, la puissance P du faisceau interférométrique en fonction du temps t sur une période de modulation égale à $2\Delta\tau$. Cette modulation 6-états peut se décomposer en une superposition d'une première modulation du déphasage $\Phi_m(t)$ de $\pm\pi/2$ à la fréquence propre $f_p$ et d'une seconde modulation du déphasage $\Phi_m(t)$ à $\pm$alpha/2 à 3fp. La seconde modulation est synchronisée avec la première modulation. Autrement dit, on obtient une différence de phase modulée $\Delta\Phi_m(t)$ de $\pm\pi$ à la fréquence propre $f_p$ (représentée en trait pointillé sur la figure 4 en bas à gauche) et de $\pm$alpha à $3f_p$ (représentée en tirets sur la figure 4 en bas à gauche). La modulation de la différence de phase résultant de la superposition de la modulation de $\pm\pi$ et de la modulation de $\pm$alpha est représentée en trait continu sur la figure 4 en bas à gauche. Cette modulation $\Delta\Phi_m(t)$ présente quatre niveaux par période de modulation. Plus généralement, on génère une différence de phase modulée $\Delta\Phi_m(t)$ de $\pm\pi$ à la fréquence propre $f_p$ et de $\pm$alpha à $(2k+1).f_p$ où k est un nombre entier naturel supérieur ou égal à 1. Les quatre niveaux de modulation sont représentés par des points sur la courbe P en fonction de la différence de phase $\Delta\Phi$. Sur la figure 4 en haut à droite, est représentée la puissance détectée P(t) en fonction du temps. On échantillonne 6 mesures de puissance sur chaque période de modulation. Avec une modulation 6-états, on extrait le signal du paramètre à mesurer, par exemple le signal Sagnac, à $3f_p$ en appliquant une démodulation multipliant par +1 les mesures de puissance correspondant aux états en + alpha et multipliant par -1 les autres mesures de puissance correspondant aux états en - alpha, indépendamment du signe de $\pm\pi$ de ces états. Dans la modulation 6-états, les états sont numérotés : i=1 pour $\pi$ - alpha ; i=2 pour $\pi$ + alpha ; i=3 pour $\pi$ - alpha ; i=4 pour - $\pi$ + alpha ; i=5 pour - $\pi$ - alpha ; et, i=6 pour- $\pi$ + alpha. Le signal de la grandeur à mesurer $S_S$ est calculé selon l'expression suivante, où les mesures de puissances $P_i$ pour les états i = 1, ..., 6 sont acquises sur une période de modulation T égale à $2\Delta\tau$.

[Math 5]

$$S_S = -P_1 + P_2 - P_3 + P_4 - P_5 + P_6$$

Dans la modulation 6-états, il est aussi possible d'extraire un signal $V_\pi$. La démodulation du signal $V_\pi$ s'obtient en multipliant les mesures de puissance échantillonnées successivement par 0, +1 et -1. En effet, comme dans le 4-états, la démodulation du signal $V_\pi$ s'obtient en multipliant les mesures $P_i$ de puissance, échantillonnées sur chaque état, par le signe du produit des signes des modulations $\pm \pi$ et $\pm$ alpha, mais tout en ne conservant qu'un même nombre d'états multipliés par le signe + et d'états multipliés par le signe -. Dans la modulation 6-états, le signal d'erreur de la fonction de transfert du modulateur est calculé selon l'expression suivante.

[Math 6]

$$S_{V_\pi} = P_2 - P_3 + P_5 - P_6$$

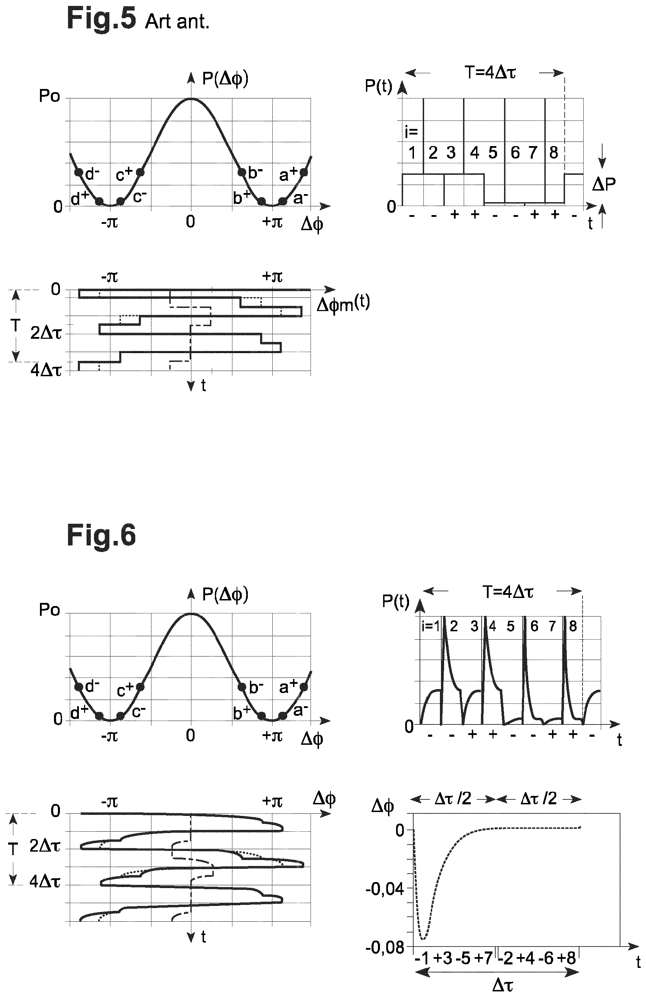

Le brevet EP2005113_B1 décrit aussi l'utilisation d'une modulation à 8 états et 8 niveaux sur une période totale T égale à $4\Delta\tau$. Selon cette modulation 8-états conventionnelle, la modulation est effectuée d'abord sur 4 états hauts correspondant à $\pm$ (alpha + beta) puis sur 4 autres états bas correspondant à $\pm$ (alpha - beta). La figure 5 représente schématiquement en haut à droite la puissance P(t) détectée en sortie du système interférométrique en fonction de la différence de phase $\Delta\Phi_m(t)$ de modulation (courbe en bas à gauche). Cette modulation $\Delta\Phi_m(t)$ présente 8 niveaux sur une période de modulation T égale à $4\Delta\tau$. Les 8 états de modulation sont numérotés de 1 à 8 sur la courbe de mesure de puissance P(t), en haut à droite, en fonction de leur ordre d'apparition sur une période de modulation. Sur la figure 5 en bas à gauche, on a représenté une modulation 4-états de $\pm\pi$ et $\pm$(alpha-beta) à la fréquence propre $f_p$ (en pointillés), une modulation additionnelle (en tirets) de -2beta, -2beta, +2beta, +2beta, zéro, zéro, zéro et zéro sur la période $4\Delta\tau$ ; et en trait continu, la modulation de la différence de phase totale résultant de la superposition de ces deux modulations. Cette modulation totale correspond donc à la succession d'une modulation 4-états de $\pm\pi$ et $\pm$(alpha+beta) sur 4 états hauts pendant une demi-période $2\Delta\tau$ et d'une modulation 4-états sur 4 états bas en $\pm\pi$ et $\pm$ (alpha-beta) sur la demi-période suivante.

Sur la partie en haut à gauche de cette figure 5, sont indiqués les différents niveaux de modulation

a+ correspond au niveau de modulation $\Delta\Phi_{a+} = \pi + $ alpha + beta
a- correspond au niveau de modulation $\Delta\Phi_{a-} = \pi + $ alpha - beta
b+ correspond au niveau de modulation $\Delta\Phi_{b+} = \pi - $ alpha + beta
b- correspond au niveau de modulation $\Delta\Phi_{b-} = \pi - $ alpha - beta
c+ correspond au niveau de modulation $\Delta\Phi_{c+} = -\pi + $ alpha +beta
c corresponds au niveau de modulation $\Delta\Phi_{c-} = -\pi + $ alpha - beta
d+ correspond au niveau de modulation $\Delta\Phi_{d+} = -\pi - $ alpha + beta
d- correspond au niveau de modulation $\Delta\Phi_{d-} = -\pi - $ alpha - beta.

La puissance de sortie P est échantillonnée en 8 mesures Pi correspondant aux 8 états i = 1, ..., 8 par période de modulation. Les niveaux de modulation correspondant à ces états sont : d- pour l'état 1 ; b- pour l'état 2 ; a+ pour l'état 3 ; c+ pour l'état 4 ; d+ pour l'état 5 ; b+ pour l'état 6 ; a- pour l'état 7 ; c- pour l'état 8. La démodulation du signal du paramètre à mesurer (Sagnac par exemple) et celle du signal $V\pi$ s'effectuent sur les 8 états de façon analogue à celles du 4-états. Dans cette modulation 8-états, le signal de la grandeur à mesurer est calculé selon l'expression suivante, où les mesures de puissances Pi pour les huit états successifs i = 1, ..., 8 sont acquises sur une période de modulation T égale à $4\Delta\tau$.

[Math 7]

$$S_S = -P_1 - P_2 + P_3 + P_4 - P_5 - P_6 + P_7 + P_8$$

Dans cette modulation 8-états, le signal d'erreur de la fonction de transfert du modulateur est calculé selon l'expression suivante.

[Math 8]

$$S_{V_\pi} = P_1 - P_2 + P_3 - P_4 + P_5 - P_6 + P_7 - P_8$$

Dans un système interférométrique à fibre optique tel que décrit ci-dessus, il est souhaitable d'ajuster la puissance de sortie sur le détecteur. A cet effet, dans le schéma de modulation 8-états décrits ci-dessus, il est connu d'extraire la fonction de transfert du système de détection de l'interféromètre, aussi appelée réponse en boucle ouverte, et noté signal $\Delta P$, de manière à asservir cette réponse en boucle ouverte par exemple en ajustant la puissance de la source lumineuse. Cette mesure se fait en détectant la différence de puissance $\Delta P$ entre les 4 états hauts (d- ; b- ; a+ ; c+) et les 4 états bas (d+ ; b+ ; a- ; c-) avec un calcul selon l'expression suivante.

[Math 9]

$$S_{\Delta P} = P_1 + P_2 + P_3 + P_4 - P_5 - P_6 - P_7 - P_8$$

Il est souhaitable d'améliorer les performances d'un système interférométrique à fibre optique à boucle ou en ligne et notamment d'augmenter la précision des mesures, la stabilité, la linéarité et/ou la dynamique de réponse d'un tel système.

**Exposé de l'invention**

Afin de remédier aux inconvénients précités de l'état de la technique, la présente invention propose un interféromètre à fibre optique en boucle ou en ligne comprenant une source lumineuse adaptée pour générer un faisceau source, un dispositif optique de séparation adapté pour séparer le faisceau source en une première onde monomode et une seconde onde monomode, un système électronique adapté pour appliquer une tension électrique de modulation $V_m$ (t) à un modulateur de phase apte à induire un même déphasage $\Phi_m(t)$ sur la première onde monomode et la seconde onde monomode, un ensemble de fibres optiques adapté pour recevoir et propager la première onde monomode suivant un premier chemin optique et, respectivement, la seconde onde monomode suivant un second chemin optique inverse du premier chemin optique, et pour former après une différence de temps de propagation $\Delta\tau$, une première onde de sortie et, respectivement, une seconde onde de sortie, ayant une différence de phase modulée $\Delta\Phi_m(t) = \Phi_m(t) - \Phi_m(t-\Delta\tau)$,

**EP 3 956 634 B1**

l'ensemble de fibre optique ayant une fréquence propre $f_p$ égale à l'inverse du double de la différence de temps de propagation $\Delta\tau$, le dispositif optique de séparation étant adapté pour recombiner la première onde de sortie et la seconde onde de sortie et former un faisceau interférométrique modulé temporellement et un système de détection adapté pour détecter une puissance P(t) du faisceau interférométrique en fonction du temps.

Plus particulièrement, on propose selon l'invention un interféromètre dans lequel la différence de phase modulée $\Delta\Phi_m(t)$ est égale à la somme d'une première différence de phase périodique $\Delta\Phi_\pi(t)$ de niveau égal à $\pm\,\pi$, d'une deuxième différence de phase $\Delta\Phi_{alpha}(t)$ périodique de niveau égal à $\pm$alpha et d'une troisième différence de phase $\Delta\Phi_{beta}(t)$ périodique de niveau variable entre -beta et +beta, alpha et beta ayant des valeurs différentes prédéterminées, de manière à ce que la différence de phase modulée $\Delta\Phi_m(t)$ ait une période de modulation T égale à un multiple impair (2M+1) du double de la différence de temps de propagation $\Delta\tau$, où M est un nombre entier naturel, la différence de phase modulée $\Delta\Phi_m(t)$ comportant par période de modulation T au moins huit niveaux de modulation parmi les douze niveaux de modulation suivants: $\Delta\Phi_{a+} = \pi$ + alpha + beta ; $\Delta\Phi_{a-} = \pi$ + alpha - beta ; $\Delta\Phi_a = \pi$ + alpha ; $\Delta\Phi_{b+} = \pi$ - alpha + beta ; $\Delta\Phi_{b-} = \pi$ - alpha - beta ; $\Delta\Phi_b = \pi$ - alpha ; $\Delta\Phi_{c+} = -\pi$ + alpha +beta ; $\Delta\Phi_{c-} = -\pi$ + alpha - beta ; $\Delta\Phi_c = -\pi$ + alpha ; $\Delta\Phi_{d+} = -\pi$ - alpha + beta ; $\Delta\Phi_{d-} = -\pi$ - alpha - beta ; $\Delta\Phi_d = -\pi$ - alpha et cette différence de phase modulée étant telle que $\Delta\Phi_m(t + T/2) = -\Delta\Phi_m(t)$ à chaque instant t compris entre 0 et T.

Selon un mode de réalisation particulier et avantageux, la période de modulation T est égale au double de la différence de temps de propagation $\Delta\tau$, la première différence de phase $\Delta\Phi_\pi(t)$ a une fréquence de modulation égale à la fréquence propre $f_p$ et la deuxième différence de phase $\Delta\Phi_{alpha}(t)$ et la troisième différence de phase $\Delta\Phi_{beta}(t)$ ont une même fréquence de modulation égale à un multiple impair (2N+1) de la fréquence propre $f_p$, où N est un nombre entier naturel non nul, la deuxième différence de phase $\Delta\Phi_{alpha}(t)$ étant synchronisée avec la première différence de phase $\Delta\Phi_\pi$(t), la troisième différence de phase $\Delta\Phi_{beta}(t)$ étant en quadrature de phase par rapport à la deuxième différence de phase $\Delta\Phi_{alpha}(t)$.

Selon un autre mode de réalisation particulier et avantageux, la période de modulation T est égale au double de la différence de temps de propagation $\Delta\tau$, la troisième différence de phase $\Delta\Phi_{beta}(t)$ ayant une fréquence de modulation égale à la fréquence propre $f_p$ et la première différence de phase $\Delta\Phi_\pi(t)$ et la deuxième différence de phase $\Delta\Phi_{alpha}(t)$ ont une même fréquence de modulation égale à un multiple impair (2N+1) de la fréquence propre $f_p$, où N est un nombre entier naturel non nul, la deuxième différence de phase étant en quadrature de phase par rapport à la première différence de phase, la troisième différence de phase $\Delta\Phi_{beta}(t)$ étant synchronisée avec la première différence de phase ou la deuxième différence de phase.

Selon encore un autre mode de réalisation particulier et avantageux, M est un nombre entier non nul, la première différence de phase $\Delta\Phi_\pi(t)$ et la deuxième différence de phase $\Delta\Phi_{alpha}(t)$ ont une même fréquence de modulation égale à la fréquence propre $f_p$, la deuxième différence de phase étant en quadrature de phase par rapport à la première différence de phase et la troisième différence de phase $\Delta\Phi_{beta}(t)$ ayant une période de modulation égale à la période de modulation T, cette troisième différence de phase étant synchronisée avec la première différence de phase ou la deuxième différence de phase.

D'autres caractéristiques non limitatives et avantageuses de l'interféromètre conforme à l'invention, prises individuellement ou selon toutes les combinaisons techniquement possibles, sont les suivantes.

Le système de détection comporte un système électronique de démodulation adapté pour extraire un signal représentatif d'une grandeur à mesurer, un signal de fonction de transfert du modulateur de phase et/ou un signal de fonction de transfert du système de détection à partir d'une série d'au moins 12 mesures de puissance du faisceau interférométrique détecté par période de modulation.

Le signal représentatif de la grandeur à mesurer est égal à une somme des mesures de puissance du faisceau interférométrique acquises par période de modulation, chaque mesure de puissance étant multipliée par -1 pour les niveaux correspondant à - alpha et par +1 pour les niveaux correspondant à + alpha.

Le signal de fonction de transfert du modulateur de phase est égal à une somme des mesures de puissance du faisceau interférométrique acquises par période de modulation, chaque mesure de puissance étant multipliée par le signe du produit du signe de la première modulation à $\pm\pi$ et du signe + ou - de la deuxième modulation à $\pm$ alpha, ou par zéro de manière à conserver un même nombre d'états multipliés par le signe + et d'états multipliés par le signe -.

Le signal de fonction de transfert du système de détection est égal à une somme des mesures de puissance du faisceau interférométrique acquises par période de modulation, chaque mesure de puissance étant multipliée par le signe du produit du signe de la deuxième modulation à $\pm$ alpha et du signe de la troisième modulation à $\pm$ beta lorsque le niveau de cette dernière modulation est +beta ou -beta, et par 0 lorsque le niveau de cette troisième modulation beta est nul.

La différence de phase modulée $\Delta\Phi_m(t)$ comporte en outre une rampe composée de marches de phase $\Delta\Phi_{FS}$ opposées à une différence de phase $\Delta\Phi_S$ du signal représentatif de la grandeur à mesurer.

Le dispositif optique de séparation est adapté pour séparer spatialement le faisceau source en la première onde monomode et la seconde onde monomode et l'ensemble de fibres optiques comporte une bobine de fibre optique adaptée pour recevoir la première onde monomode à une première extrémité de la bobine de fibre optique et, respectivement, la seconde onde monomode à une seconde extrémité de la bobine de fibre optique, la première onde monomode et la seconde onde monomode se propageant en sens inverse dans la bobine de fibre optique.

La première onde monomode et la seconde onde monomode sont polarisées linéairement et la bobine de fibre optique est à maintien de polarisation linéaire, l'interféromètre étant adapté pour mesurer une différence de phase représentative d'une rotation autour d'un axe de la bobine de fibre optique.

L'ensemble de fibres optiques comporte une section de fibre optique à maintien de polarisation linéaire, la bobine de fibre optique à maintien de polarisation circulaire et une autre section de fibre optique à maintien de polarisation linéaire, une lame quart d'onde étant disposée entre la section de fibre optique et une extrémité de la bobine de fibre optique, une autre lame quart d'onde étant disposée entre l'autre section de fibre optique et l'autre extrémité de la bobine de fibre optique, l'interféromètre étant adapté pour mesurer une différence de phase induite par un courant électrique traversant la bobine de fibre optique.

L'ensemble de fibres optiques comporte une section de fibre optique à maintien de polarisation linéaire et une bobine de fibre optique à maintien de polarisation circulaire, la section de fibre optique étant reliée à une extrémité de la bobine de fibre optique, un miroir étant disposé à une seconde extrémité de la bobine de fibre optique, l'interféromètre étant adapté pour mesurer une différence de phase induite par un courant électrique traversant la bobine de fibre optique.

L'interféromètre comprend un système de rétroaction adapté pour asservir la mesure du signal représentatif de la grandeur à mesurer, du signal de fonction de transfert du modulateur de phase et/ou du signal de fonction de transfert du système de détection.

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

L'interféromètre à fibre optique de la présente divulgation permet d'améliorer la précision des mesures de la grandeur à mesurer, par exemple du déphasage Sagnac, en s'affranchissant des erreurs induites par la constante de temps RC du circuit électrique de commande du modulateur de phase, qui affecte notamment les mesures obtenues par une modulation 8-états conventionnelle. L'interféromètre à fibre optique de la présente divulgation permet aussi de mesurer la fonction de transfert de l'interféromètre par la mesure de différence de puissance $\Delta P$ entre états hauts et états bas.

## Brève description des dessins

De plus, diverses autres caractéristiques de l'invention ressortent de la description annexée effectuée en référence aux dessins qui illustrent des formes, non limitatives, de réalisation de l'invention et où :

[Fig. 1] représente schématiquement un système interférométrique de Sagnac à fibre optique en boucle pour application à un gyroscope à fibre optique selon l'art antérieur;

[Fig. 2] représente un modulateur de phase dans un système interférométrique à fibre optique en boucle, pour générer une différence de phase modulée $\Delta\Phi_m(t)$ pour la mise au biais du signal selon l'art antérieur;

[Fig. 3] représente schématiquement un exemple de différence de phase modulée $\Delta\Phi_m(t)$ appliquée sur un modulateur de phase, suivant une modulation 4-états de l'art antérieur, la position des 4 états de modulation sur la courbe de réponse de l'interféromètre et les 4 mesures de puissance P(t) détectée en fonction du temps ici sur trois périodes de modulation ;

[Fig. 4] représente schématiquement un exemple de différence de phase modulée $\Delta\Phi_m(t)$ appliquée sur un modulateur de phase, suivant une modulation 6-états de l'art antérieur, la position des 6 états de modulation sur la courbe de réponse de l'interféromètre et les 6 mesures de puissance P(t) détectée en fonction du temps sur une période de modulation ;

[Fig. 5] représente schématiquement un exemple de différence de phase modulée $\Delta\Phi_m(t)$ appliquée sur un modulateur de phase, suivant une modulation 8-états de l'art antérieur, la position des 8 états de modulation sur la courbe de réponse de l'interféromètre et les 8 mesures de puissance P(t) détectée en fonction du temps ;

[Fig. 6] représente schématiquement la différence de phase modulée appliquée en présence d'une constante de temps RC de la chaine de modulation de phase, dans une modulation 8-états conventionnelle, l'effet de la constante de temps RC sur la puissance P(t) du système interférométrique et le signal parasite résiduel en absence de rotation d'un système interférométrique Sagnac obtenu par démodulation classique de cette modulation 8-états ;

[Fig. 7] illustre un premier mode de réalisation basé sur une modulation à 8 niveaux de $\Delta\Phi_m(t)$ et 12 états de la puissance P(t) détectée correspondante ;

[Fig. 8] illustre un deuxième mode de réalisation basé sur une modulation à 8 niveaux de $\Delta\Phi_m(t)$ et 12 états de la puissance P(t) détectée correspondante ;

[Fig. 9] illustre un troisième mode de réalisation basé sur une modulation à 8 niveaux de $\Delta\Phi_m(t)$ et 12 états de la puissance P(t) détectée correspondante ;

[Fig. 10] représente schématiquement, un exemple de modulation suivant le troisième mode de réalisation et la puissance P(t) détectée en présence d'un signal Sagnac ;

[Fig. 11] représente schématiquement un système interférométrique à fibre optique en boucle pour application à un capteur de courant électrique selon la présente divulgation ;

[Fig. 12] représente schématiquement un système interférométrique à fibre optique en ligne pour application à un capteur de courant électrique selon la présente divulgation ;

[Fig. 13] représente schématiquement un autre système interférométrique à fibre optique en ligne pour application à un capteur de courant électrique selon la présente divulgation.

Il est à noter que sur ces figures les éléments structurels et/ou fonctionnels communs aux différentes variantes peuvent présenter les mêmes références.

## Description détaillée

Dans un système interférométrique à modulation de phase tel que décrit en lien avec la figure 1, le modulateur de phase 16 est alimenté avec un circuit électrique de commande qui a un temps de réponse RC, aussi appelé constante de temps, lié à la résistance de charge R entre les électrodes de ce modulateur de phase et à la capacité électrique C de ces électrodes. La résistance R est de l'ordre de 50 à 500 ohms. La capacité électrique d'une électrode de 10 mm de long d'un modulateur sur circuit optique intégré (par exemple de niobate de lithium) est de l'ordre de 3 pF, soit une capacité C d'environ 12 pF pour une paire d'électrodes push-pull de 20 mm de long. Dans ce cas, on peut estimer la valeur de la constante de temps RC du modulateur de phase à environ 1 à 10 ns. De manière générale, la constante de temps RC du circuit de commande d'un modulateur de phase est comprise entre 0, 5 et 50 ns. On peut noter qu'avec certains montages électriques, il n'y a pas de résistance de charge entre les électrodes et cette constante de temps est alors donnée par le produit gain-bande de l'amplificateur du circuit de commande.

La présente divulgation montre que cette constante de temps RC peut influencer les performances d'un système interférométrique et propose différents schémas de modulation et de démodulation pour réduire ou même annuler les effets négatifs induits par la constante de temps RC du modulateur de phase.

La figure 6 illustre le cas d'une modulation classique à 8 états sur laquelle on fait apparaitre l'effet du temps de réponse électrique RC du modulateur de phase. Pour faire apparaitre graphiquement l'effet du temps de réponse électrique RC sur la figure 6 on a choisi une valeur élevée de RC : RC = $\Delta\tau/12$. La figure 6 représente schématiquement la puissance P(t) détecté en sortie du système interférométrique en fonction d'une part de la différence de phase $\Delta\Phi$ (courbe en haut à gauche) et, d'autre part, du temps t (courbe en haut à droite). La figure 6 représente aussi la différence de phase modulée $\Delta\Phi_m(t)$ en fonction du temps (courbe en bas à gauche). Sur cette courbe de différence de phase modulée $\Delta\Phi_m(t)$ en fonction du temps, on observe que cette différence de phase ne suit pas la forme carrée idéale mais suit une courbe en exponentielle qui atteint chaque niveau de différence de phase avec un retard lié à la constante de temps RC.

Enfin, la figure 6 représente, en bas à droite, une courbe temporelle de différence de puissance entre les états 1 et 3, et 5 et 7 ainsi que 2 et 4 et 6 et 8, tels qu'ils sont démodulés pour mesurer la différence de phase signal $\Delta\Phi_S$ avec une démodulation conventionnelle (voir équation Math 7) dans un interféromètre à 8 états en absence de rotation de cet interféromètre de Sagnac.

En effet, lorsque le processeur numérique 10 et le convertisseur numérique-analogique 11 génèrent un signal de commande $C_m(t)$ de modulation carrée commutant entre deux paliers, le temps de réponse électrique RC fait que la tension de commande $V_m(t)$ effectivement appliquée au modulateur et la différence de phase modulée $\Delta\Phi_m(t)$ qu'elle génère n'atteignent pas instantanément le niveau souhaité. Plus précisément, chaque niveau de différence de phase modulée $\Delta\Phi_m(t)$ suit une courbe exponentielle en (1 - exp(-t/RC)) qui part du niveau précédent et tend de manière asymptotique vers la valeur souhaitée pour ce niveau. Sur la courbe de puissance P en fonction du temps, il en résulte que deux états du signal interférométrique mesuré correspondant théoriquement à un même niveau de puissance mais partant de niveaux précédents différents ne sont en fait pas identiques car ils n'ont pas le même historique. Pour la modulation 8-états, la démodulation classique du signal relatif à la grandeur mesurée est basée sur des différences entre les puissances mesurées pour les paires d'états 1 et 3, 5 et 7, 2 et 4, 6 et 8 (voir équation Math 7). Notamment, l'état 8, qui précède l'état 1 (modulo T), est de niveau inférieur à l'état 2, qui précède l'état 3, si bien que les états 1 et 3 ne sont pas parfaitement identiques, n'ayant pas le même historique, et que leur différence qui est calculée dans la démodulation n'est pas parfaitement nulle en absence de rotation, donc quand $\Delta\Phi_S = 0$. De même, l'état 4, précédant l'état 5, est de niveau supérieur à l'état 6, précédant l'état 7, si bien que les états 5 et 7 ne sont pas non plus identiques, n'ayant pas non plus le même historique. Or, il est fondamental que la démodulation du signal de la grandeur à mesurer donne bien zéro et ne génère aucun défaut lorsque le paramètre à mesurer dans l'interféromètre est nul, notamment aucun défaut dans un interféromètre de Sagnac en absence de rotation.

Sur la courbe en bas à droite de la figure 6, on observe bien que la différence de puissance calculée dans la démodulation de la grandeur à mesurer n'est pas nulle, en particulier pour la différence entre les états 1 et 3 ainsi que 5 et 7. Un tel système interférométrique de l'art antérieur génère donc des défauts. L'ordre de grandeur de ces défauts peut correspondre à une différence de phase parasite de l'ordre de $10^{-4}$ à $10^{-5}$ radian, alors qu'on cherche une stabilité de zéro de l'ordre de $10^{-8}$ à $10^{-9}$ radian.

La présente divulgation propose différentes techniques de modulation et de démodulation adaptées pour atténuer ou même supprimer les défauts induits par la constante de temps RC du circuit de commande du modulateur de phase dans un système interférométrique générant au moins 8 niveaux par période de modulation et 12 états par période de démodulation.

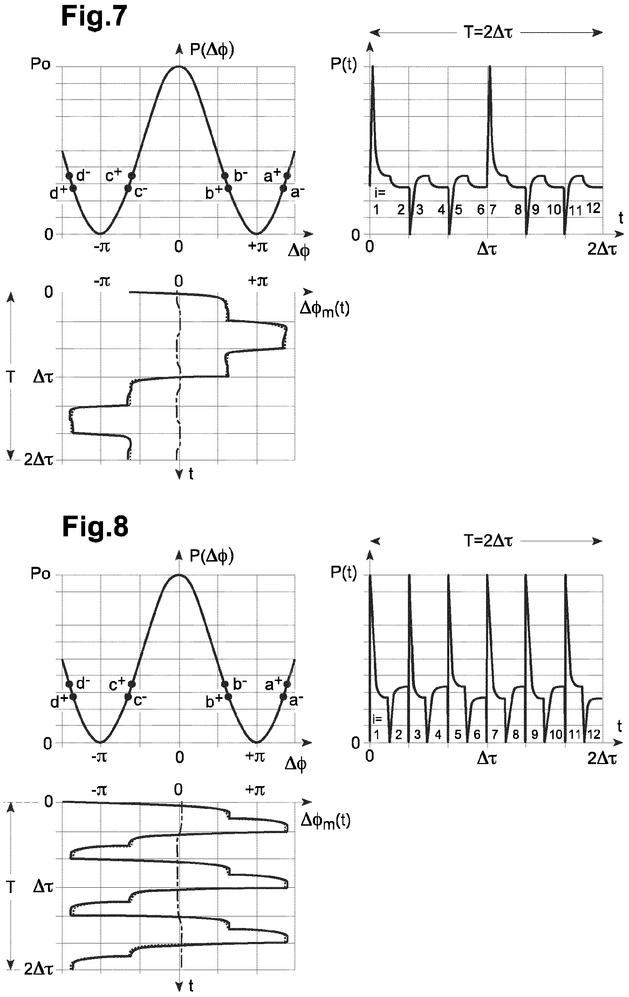

La figure 7 illustre un premier mode de réalisation basé sur une modulation à 8 niveaux de modulation et 12 états.

Dans la suite du présent document on entend par niveau (ou niveau de modulation) la valeur asymptotique des différentes valeurs de différence de phase modulée $\Delta\Phi_m$ pour chaque palier de modulation. On entend par états de modulation, les différentes valeurs de puissance P mesurées correspondant aux niveaux de modulation qui s'enchainent sur chaque période de modulation. Sur une période de modulation, plusieurs états peuvent utiliser un même niveau de modulation.

Dans le premier mode de réalisation, en lien avec la figure 7, on applique une tension de modulation suivant 8 niveaux sur une période de modulation T égale à $2\Delta\tau$. Plus précisément, on applique un signal de commande $C_m(t)$ de modulation en créneaux constituée de la somme de trois modulations carrées. La première modulation carrée est adaptée pour induire une première différence de phase $\Delta\Phi_\pi(t)$ égale à $\pm \pi$. La première différence de phase $\Delta\Phi_\pi(t)$ est périodique à la fréquence propre $f_p$. La deuxième modulation carrée est adaptée pour induire une deuxième différence de phase $\Delta\Phi_{alpha}(t)$ égale à $\pm$ alpha. La deuxième différence de phase $\Delta\Phi_{alpha}(t)$ est périodique et a une fréquence de modulation égale à un multiple impair (2N+1) de la fréquence propre $f_p$, où N est un nombre entier naturel supérieur ou égal à 1. La deuxième différence de phase $\Delta\Phi_{alpha}(t)$ est synchronisée avec la première différence de phase $\Delta\Phi_\pi(t)$. La troisième modulation carrée est adaptée pour induire une troisième différence de phase $\Delta\Phi_{beta}(t)$ égale à $\pm$ beta. La troisième différence de phase $\Delta\Phi_{beta}(t)$ est périodique et a une fréquence de modulation égale au même multiple impair (2N+1) de la fréquence propre $f_p$. La troisième différence de phase $\Delta\Phi_{beta}(t)$ est en quadrature de phase par rapport à la deuxième différence de phase $\Delta\Phi_{alpha}(t)$, autrement dit retardée de T/12 par rapport à la deuxième différence de phase $\Delta\Phi_{alpha}(t)$ dans le cas de la figure où 2N+1=3. Dans le cas général, c'est un retard de T/(4(2N+1)). La différence de phase modulée $\Delta\Phi_m(t)$ résultante de cette modulation est égale à la somme de la première différence de phase périodique $\Delta\Phi_\pi(t)$, de la deuxième différence de phase $\Delta\Phi_{alpha}(t)$ et de la troisième différence de phase $\Delta\Phi_{beta}(t)$ suivant l'équation suivante.

[Math 10]

$$\Delta\Phi_m(t) = \Delta\Phi_\pi(t) + \Delta\Phi_{alpha}(t) + \Delta\Phi_{beta}(t)$$

Dans l'exemple illustré sur la figure 7, le nombre N est égal à 1, la fréquence de la deuxième différence de phase $\Delta\Phi_{alpha}(t)$ et de la troisième différence de phase $\Delta\Phi_{beta}(t)$ est égale à $3f_p$ et on a choisi les valeurs suivantes pour alpha et beta : alpha = $3\pi/8$ et beta = $3\pi/128$. La période T vaut $2\Delta\tau$, sachant que $\Delta\tau$ est de l'ordre de 5 μs pour un kilomètre. La constante RC a été exagérée par rapport à la réalité pour rendre la figure 7 plus lisible. RC vaut ici environ 1/20 de $\Delta\tau$.

Sur la courbe $\Delta\Phi_m(t)$ de la figure 7, on a représenté en traits pointillés la modulation suivant 6 états/4 niveaux résultant de la somme de la première différence de phase $\Delta\Phi_\pi(t)$ modulée à $f_p$ et de la deuxième différence de phase $\Delta\Phi_{alpha}(t)$ modulée à $3f_p$. On a représenté en traits tiretés la troisième différence de phase $\Delta\Phi_{beta}(t)$ modulée sur 2 niveaux à 3fp en quadrature de phase relativement à la deuxième différence de phase $\Delta\Phi_{alpha}(t)$. Enfin, on a représenté en trait continu la différence de phase modulée $\Delta\Phi_m(t)$ ou modulation totale résultant de la somme de la modulation en pointillés et de la modulation en tirets. La différence de phase modulée $\Delta\Phi_m(t)$ présente 8 niveaux par période $T=2\Delta\tau$. Toutefois, cette modulation sur 8 niveaux est différente de la modulation sur 8 niveaux de l'art antérieur (illustrée par exemple sur les figures 5 et 6). On observe l'effet de la constante de temps RC sur la courbe de la différence de phase modulée $\Delta\Phi_m(t)$. Chaque niveau de différence de phase modulée suit une courbe exponentielle en (1 - exp(-t/RC)) qui part du niveau précédent.

A chaque période T, cette modulation de la différence de phase $\Delta\Phi_m(t)$ génère les 8 niveaux de modulation suivants $\Delta\Phi_m(t) = \pm\pi\pm$ alpha $\pm$ beta. Ces huit niveaux de modulation correspondent aux points notés $a^+$, $a^-$, $b^+$, $b^-$, $c^+$, $c^-$, $d^+$ et $d^-$ sur la courbe de puissance en fonction de la différence de phase.

Sur la figure 7

$$\Delta\Phi_{a+} = \pi + alpha + beta$$

$a^-$ correspond au niveau de modulation

$$\Delta\Phi_{a-} = \pi + alpha - beta$$

$b^+$ correspond au niveau de modulation

$$\Delta\Phi_{b+} = \pi - alpha + beta$$

$b^-$ correspond au niveau de modulation

$$\Delta\Phi_{b-} = \pi - alpha - beta$$

$c^+$ correspond au niveau de modulation

$$\Delta\Phi_{c+} = -\pi + alpha + beta$$

$c^-$ correspond au niveau de modulation

$$\Delta\Phi_{c-} = -\pi + alpha - beta$$

$d^+$ correspond au niveau de modulation

$$\Delta\Phi_{d+} = -\pi - alpha + beta$$

$d^-$ correspond au niveau de modulation

$$\Delta\Phi_{d-} = -\pi - alpha - beta.$$

Sur la courbe de puissance de sortie P en fonction du temps, les 8 niveaux de différence de phase modulée $\Delta\Phi_m$(t) s'enchainent en une séquence de 12 états par période de modulation T dans l'ordre suivant : $b^-$ $b^+$ $a^+$ $a^-$ $b^-$ $b^+$ $c^+$ $c^-$ $d^-$ $d^+$ $c^+$ $c^-$.

Le détecteur recevant le faisceau interférométrique acquiert 12 mesures $P_i$ de puissance par période de modulation T correspondant aux douze états i = 1,..., 12. Autrement dit, le détecteur échantillonne le signal de puissance P à la fréquence 12 $f_p$. Plus généralement, pour une modulation de la deuxième différence de phase $\Delta\Phi_{alpha}(t)$ et de la troisième différence de phase $\Delta\Phi_{beta}(t)$ à $(2N+1).f_p$, on échantillonne à $4.(2N+1).f_p$. Sur la courbe de puissance en fonction du temps, on observe clairement l'effet de la constante de temps RC du circuit de commande du modulateur de phase sur les mesures de puissance détectée. La valeur de chaque mesure de puissance $P_i$ atteint un plateau suivant une courbe en exponentielle qui dépend de l'écart entre les deux valeurs asymptotiques successives de puissance.

Selon le signal recherché, on applique une démodulation spécifique. Plus précisément, pour extraire le signal de la grandeur à mesurer, par exemple le signal Sagnac, on utilise une démodulation des 12 états acquis. Sur la période de modulation T égale à $2\Delta\tau$, on applique les signes dans l'ordre suivant aux 12 mesures de puissance Pi : - - + + - - + + - - + +. Autrement dit, on multiplie la mesure de puissance $P_i$ par -1 pour les niveaux correspondant à - alpha et par +1 pour les niveaux correspondant à + alpha, indépendamment du signe des modulations à $\pm\pi$ et $\pm$ beta. Ainsi, la démodulation du signal de la grandeur à mesurer modulée sur 12 états s'exprime comme suit dans le premier mode de réalisation.

[Math 11]

$$S_S = -P_1 - P_2 + P_3 + P_4 - P_5 - P_6 + P_7 + P_8 - P_9 - P_{10} + P_{11} + P_{12}$$

On observe, sur la courbe de puissance en fonction du temps, que la modulation à 8 niveaux et 12 états présente, pour chaque état démodulé avec le signe +, un état identique, c'est-à-dire un état avec le même historique, démodulé avec le signe -. Ainsi, l'état 1 correspondant au niveau b⁻ est identique à l'état 7 correspondant au niveau c⁺ ; l'état 2 correspondant au niveau b⁺ est identique à l'état 8 correspondant au niveau c⁻ ; l'état 3 correspondant au niveau a⁺ est identique à l'état 9 correspondant au niveau d⁻ ; l'état 4 correspondant au niveau a⁻ est identique à l'état 10 correspondant au niveau d⁺ ; l'état 5 correspondant au niveau b⁻ est identique à l'état 11 correspondant au niveau c⁺ ; l'état 6 correspondant au niveau b⁺ est identique à l'état 12 correspondant au niveau c⁻. Autrement dit, à chaque état de la première demi-période T/2, démodulé pour en extraire la grandeur à mesurer, en + ou en -, correspond un état de même historique, démodulé avec le signe inverse, dans la deuxième demi-période. On observe que la différence de phase modulée $\Delta\Phi_m(t)$ suivant la modulation 8 niveaux et 12 états du premier mode de réalisation vérifie l'équation suivante à tout instant t d'une période de modulation T, ici compris entre 0 et $2\Delta\tau$.

[Math 12]

$$\Delta\Phi_m\left(t + \frac{T}{2}\right) = -\Delta\Phi_m(t)$$

Il en résulte que la démodulation d'un signal modulé suivant 8 niveaux et 12 états telle que décrite ci-dessus, pour extraire le signal de la grandeur à mesurer, par exemple le signal Sagnac, ne présente pas de défaut induit par la constante de temps RC, contrairement à une démodulation d'un signal modulé suivant une modulation conventionnelle à 8 niveaux et 8 états.

Dans le premier mode de réalisation, la démodulation de la fonction de transfert du modulateur de phase, notée $V_\pi$, est effectuée en multipliant les mesures de puissance $P_i$ pour i = 1, ..., 12 acquises sur une période de modulation T, par le signe du produit du signe + ou - de la modulation à $\pm\pi$ et du signe + ou - de la modulation à $\pm$ alpha, indépendamment du signe de la modulation à $\pm$ beta, ou par zéro de manière à ne conserver qu'autant d'états multipliés par + que d'états multipliés par -. La démodulation de la fonction de transfert du modulateur de phase, notée $V_\pi$, s'exprime comme suit dans le premier mode de réalisation.

[Math 13]

$$S_{V_\pi} = +P_3 + P_4 - P_5 - P_6 + P_9 + P_{10} - P_{11} - P_{12}$$

Dans le premier mode de réalisation, la démodulation de la fonction de transfert du système de détection, ou réponse en boucle ouverte, notée $\Delta P$, est effectuée à la fréquence $6f_p$ en multipliant les 12 mesures de puissance $P_i$ pour i = 1, ..., 12 acquises sur une période de modulation T, par le signe du produit du signe + ou - de la modulation $\pm$ alpha et du signe + ou - de la modulation $\pm$ beta, indépendamment du signe de la modulation $\pm$ π. Dans l'exemple illustré sur la figure 7, pour extraire $\Delta P$ on échantillonne à $12f_p$. Les niveaux hauts en a⁺ et c⁺ correspondant à une modulation (+alpha+beta) et les niveaux hauts en b⁻ et d⁻ correspondant à une modulation (-alpha-beta) sont démodulés en multipliant par +1, tandis que les niveaux bas en a⁻ et c correspondant à une modulation (+alpha-beta) et les niveaux bas en b⁺ et d⁺ correspondant à une modulation (-alpha+beta) sont démodulés en multipliant par -1. Plus précisément, la démodulation de la fonction de transfert du système de détection, donc la différence de puissance $\Delta P$ entre états hauts et états bas, modulée sur 12 états s'exprime comme suit dans le premier mode de réalisation.

[Math 14]

$$S_{\Delta P} = +P_1 - P_2 + P_3 - P_4 + P_5 - P_6 + P_7 - P_8 + P_9 - P_{10} + P_{11} - P_{12}$$

Le premier mode de réalisation basé sur une modulation de $\pm$ π à $f_p$, $\pm$ alpha à $3f_p$ et $\pm$ beta à $3f_p$ induisant 8 niveaux de modulation et 12 états par période T permet d'extraire par une démodulation adaptée le signal de la grandeur à mesurer, le signal $V_\pi$ et le signal de réponse en boucle ouverte $\Delta P$, le signal de la grandeur à mesurer étant corrigé de défauts induits par la constante de temps RC du circuit de commande du modulateur de phase. Ce schéma de modulation et démodulation permet d'améliorer les performances d'un système interférométrique sans modifier sa structure et permet une mise à niveau de systèmes interférométriques existants.

Nous décrivons maintenant un deuxième mode de réalisation en lien avec la figure 8. De manière analogue au premier mode de réalisation, le deuxième mode de réalisation est basé sur une modulation à au moins 8 niveaux de modulation et 12 états par période de modulation T égale à $2\Delta\tau$.

La modulation est aussi appliquée suivant 8 niveaux par période de modulation T. Le signal de commande $C_m(t)$ est ici aussi constituée de la somme de trois modulations carrées. Dans ce deuxième mode de réalisation, la première modulation carrée induit une première différence de phase $\Delta\Phi_\pi(t)$ de niveau égal à $\pm \pi$. La première différence de phase est périodique et a une fréquence de modulation égale à un multiple impair $(2N+1)$ de la fréquence propre $f_p$, où N est un nombre entier naturel supérieur ou égal à 1. La deuxième tension de modulation carrée est adaptée pour induire une deuxième différence de phase $\Delta\Phi_{alpha}(t)$ de niveau égal à $\pm$ alpha. La deuxième différence de phase $\Delta\Phi_{alpha}(t)$ est périodique et a une fréquence de modulation égale au même multiple impair $(2N+1)$ de la fréquence propre $f_p$, où N est un nombre entier naturel supérieur ou égal à 1. La deuxième différence de phase $\Delta\Phi_{alpha}(t)$ est en quadrature par rapport à la première différence de phase $\Delta\Phi_\pi(t)$. La troisième tension de modulation carrée est adaptée pour induire une troisième différence de phase $\Delta\Phi_{beta}(t)$ de niveau égal à $\pm$ beta. La troisième différence de phase $\Delta\Phi_{beta}(t)$ est périodique et a une fréquence de modulation égale à $f_p$ synchronisée avec la première différence de phase $\Delta\Phi_\pi(t)$.

Dans l'exemple illustré sur la figure 8, la première différence de phase $\Delta\Phi_\pi(t)$ et la deuxième différence de phase $\Delta\Phi_{alpha}(t)$ sont à la fréquence $3f_p$ et on choisit les valeurs suivantes pour alpha et beta : alpha = $3\pi/8$ et beta = $3\pi/128$, et RC = $\Delta\tau/20$.

Sur la courbe $\Delta\Phi_m(t)$ de la figure 8, on a représenté en traits pointillés la modulation suivant 4 états résultant de la somme de la première différence de phase périodique $\Delta\Phi_\pi(t)$ modulée à $3f_p$ et de la deuxième différence de phase $\Delta\Phi_{alpha}(t)$ modulée à $3f_p$ en quadrature par rapport à $\Delta\Phi_\pi(t)$. On a représenté en traits tiretés la troisième différence de phase $\Delta\Phi_{beta}(t)$ modulée sur 2 niveaux à la fréquence $f_p$. Enfin, on a représenté en trait continu la différence de phase modulée $\Delta\Phi_m(t)$ ou modulation totale résultant de la somme de la modulation en pointillés et de la modulation en traits tiretés. La différence de phase modulée $\Delta\Phi_m(t)$ présente aussi 8 niveaux. On observe l'effet de la constante de temps RC sur la courbe de la différence de phase modulée $\Delta\Phi_m(t)$. Chaque niveau de différence de phase modulée suit une courbe exponentielle en (1 - exp(-t/RC)) qui part du niveau précédent.

Comme dans le premier mode de réalisation, la différence de phase modulée $\Delta\Phi_m(t)$ comporte 8 niveaux et cette différence de phase modulée $\Delta\Phi_m(t)$ sur 8 niveaux génère 12 états de modulation sur la courbe de puissance de sortie en fonction du temps, dans l'ordre suivant : $b^+$ $a^+$ $c^-$ $d^-$ $b^-$ $a^-$ $c^-$ $d^-$ $b^+$ $a^+$ $c^+$ $d^+$ correspondant aux différences de phase $\Delta\Phi_{a+}$ à $\Delta\Phi_{d-}$ indiquées plus haut.

Le détecteur acquiert 12 mesures de puissance $P_i$ par période de modulation T correspondant aux douze états i = 1,..., 12. Sur la courbe de puissance en fonction du temps, on observe ici aussi clairement l'effet de la constante de temps RC du modulateur de phase sur les mesures de puissance détectées.

Dans le deuxième mode de réalisation, la démodulation du signal de la grandeur à mesurer, par exemple le signal Sagnac, est analogue à celle du premier mode de réalisation dans la mesure où on multiplie la mesure de puissance $P_i$ pour i= 1, 2, ..., 12 sur une période de modulation par -1 pour les niveaux correspondant à - alpha et par +1 pour les niveaux correspondant à + alpha, indépendamment du signe des modulations à $\pm\pi$ et $\pm$ beta. Ce schéma de démodulation se traduit par l'expression suivante dans le deuxième mode de réalisation.

[Math 15]

$$S_S = - P_1 + P_2 + P_3 - P_4 - P_5 + P_6 + P_7 - P_8 - P_9 + P_{10} + P_{11} - P_{12}$$

Ainsi, à chaque état de la première demi-période T/2, démodulé en plus ou en moins, correspond un état de même historique sur la deuxième demi-période, démodulé en sens inverse, soit en moins ou en plus : les paires 1-7, 2-8, 3-9, 4-10, 5-11 et 6-12 permettent de supprimer les effets induits par le RC du modulateur de phase. En effet, dans le deuxième mode de réalisation, on observe sur la figure 8 que la différence de phase modulée $\Delta\Phi_m(t)$ suivant la modulation 8 niveaux et 12 états vérifie l'équation Math 12 à tout instant t de la période de modulation, ici compris entre 0 et $2\Delta\tau$.

De même, la démodulation de la fonction de transfert du modulateur de phase, notée démodulation du $V_\pi$, est effectuée en multipliant les 12 mesures de puissance $P_i$ pour i = 1, ..., 12 acquises sur une période de modulation T, par le signe du produit du signe + ou - de la modulation à $\pm\pi$ et du signe + ou - de la modulation à $\pm$ alpha, indépendamment du signe de la modulation à $\pm$ beta.

Ainsi, la démodulation de la fonction de transfert du modulateur de phase, notée démodulation du $V_\pi$, sur 12 états s'exprime dans le deuxième mode de réalisation par l'expression suivante.

[Math 16]

$$S_{V_\pi} = -P_1 + P_2 - P_3 + P_4 - P_5 + P_6 - P_7 + P_8 - P_9 + P_{10} - P_{11} + P_{12}$$

Enfin, la démodulation de la fonction de transfert du système de détection, notée démodulation du $\Delta$P, est effectuée en multipliant les 12 mesures de puissance $P_i$ pour i = 1, ..., 12 acquises sur une période de modulation T, par le signe du produit du signe + ou - de la modulation à $\pm$ alpha et du signe + ou - de la modulation à $\pm$ beta, indépendamment du signe de la modulation à $\pm \pi$.

Ainsi, la démodulation de la fonction de transfert du système de détection, notée $\Delta$P, sur 12 états s'exprime comme suit dans le deuxième mode de réalisation.

[Math 17]

$$S_{\Delta P} = -P_1 + P_2 - P_3 + P_4 + P_5 - P_6 - P_7 + P_8 - P_9 + P_{10} + P_{11} - P_{12}$$

Dans le deuxième mode de réalisation, le signal de la grandeur à mesurer est également corrigé des défauts induits par la constante de temps RC du modulateur de phase.

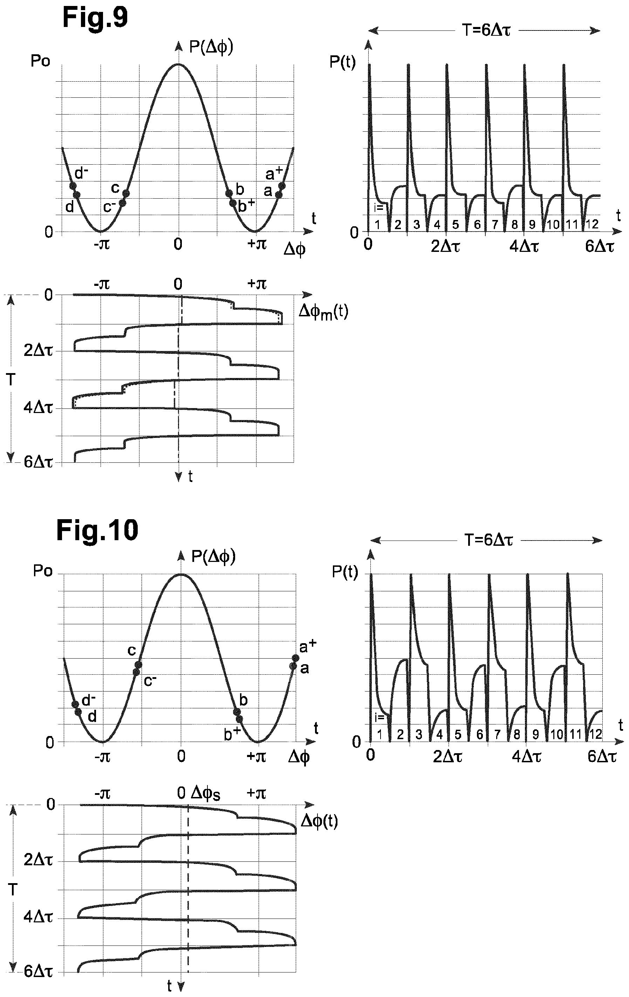

Nous décrivons maintenant un troisième mode de réalisation en lien avec la figure 9. Le troisième mode de réalisation est basé sur une modulation à 12 états et 8 niveaux de modulation par période de modulation T.

Le signal de commande $C_m(t)$ est aussi constituée de la somme de trois modulations carrées. Dans le troisième mode de réalisation, la première modulation carrée induit une première différence de phase $\Delta\Phi_\pi(t)$ de niveau égal à $\pm \pi$. La première différence de phase est périodique et a une fréquence de modulation égale à la fréquence propre $f_p$. La deuxième modulation carrée est adaptée pour induire une deuxième différence de phase $\Delta\Phi_{alpha}(t)$ de niveau égal à $\pm$ alpha. La deuxième différence de phase $\Delta\Phi_{alpha}(t)$ est périodique et de fréquence de modulation égale la fréquence propre $f_p$, en quadrature par rapport à la première différence de phase $\Delta\Phi_\pi(t)$. Autrement dit, la somme de la première différence de phase et de la deuxième différence de phase $\Delta\Phi_{alpha}(t)$ produit une modulation 4-états (en pointillés sur la courbe de différence de phase modulée en fonction du temps de la figure 9). La troisième modulation carrée est adaptée pour induire un déphasage $\Phi_{beta}(t)$ de niveau égal à $\pm$ beta/2. Cette modulation $\Phi_{beta}(t)$ est périodique et a une fréquence de modulation égale à une sous-harmonique impaire de la fréquence propre : $f_p/(2N+1)$, où N est un nombre entier naturel supérieur ou égal à 1. La période de modulation est alors égale à $2.(2N+1).\Delta\tau$. La troisième modulation $\Phi_{beta}(t)$ est synchronisée avec la première différence de phase $\Delta\Phi_\pi(t)$ ou la deuxième différence de phase $\Delta\Phi_{alpha}(t)$. La troisième modulation $\Phi_{beta}(t)$ du déphasage induit une différence de phase $\Delta\Phi_{beta}(t) = \Phi_{beta}(t) - \Phi_{beta}(t- \Delta\tau)$ sur 6 niveaux qui commutent tous les $\Delta\tau$ selon la séquence suivante : +beta, 0, 0, -beta, 0, 0 (représentée en traits tiretés sur la courbe de différence de phase modulée en fonction du temps de la figure 9).

Dans l'exemple illustré sur la figure 9, la fréquence de modulation du déphasage $\Phi_{beta}(t)$ est égale à $f_p/3$ et la période de modulation T est égale à $6\Delta\tau$. Dans l'exemple illustré sur la figure 9, on choisit les valeurs suivantes pour alpha et beta : alpha = $3\pi/8$ et beta = $5\pi/128$. La valeur de RC est exagérée par rapport à la réalité pour rendre la figure 9 plus lisible et vaut ici $\Delta\tau/10$.

La différence de phase modulée $\Delta\Phi_m(t)$ ou modulation totale résultant de la somme de la modulation en pointillés et de la modulation en traits tiretés a une période de modulation T égale à $(2N+1).2\Delta\tau$. Dans l'exemple de la figure 9, la différence de phase modulée $\Delta\Phi_m(t)$ induit 8 niveaux par période de modulation T. Ces 8 niveaux de modulation produisent sur la courbe de mesure de puissance une séquence de 12 états, qui commutent tous les $\Delta\tau/2$ selon l'ordre d'apparition suivant sur une période de modulation T : $b^+$ $a^+$ c d b a $c^-$ $d^-$ b a c d.

Sur la figure 9, a+ correspond au niveau de modulation $\Delta\Phi_{a+} = \pi$ + alpha + beta ; a correspond au niveau de modulation $\Delta\Phi_a = \pi$ + alpha ; $b^+$ correspond au niveau de modulation $\Delta\Phi_{b+} = \pi$ - alpha + beta ; b correspond au niveau de modulation $\Delta\Phi_b = \pi$ - alpha ; c correspond au niveau de modulation $\Delta\Phi_c = -\pi$ + alpha ; $c^-$ correspond au niveau de modulation $\Delta\Phi_{c-} = -\pi$ + alpha - beta ; d correspond au niveau de modulation $\Delta\Phi_d = -\pi$ - alpha ; $d^-$ correspond au niveau de modulation $\Delta\Phi_{d-} = -\pi$ - alpha - beta.

Sur la courbe de puissance de sortie P fonction de la différence de phase $\Delta\Phi$ de la figure 9, les niveaux de différence de phase modulée $\Delta\Phi_m(t)$ génèrent 12 états de modulation par période de modulation. Sur la figure 9, on observe que la différence de phase modulée $\Delta\Phi_m(t)$ suivant la modulation 8 niveaux et 12 états du troisième mode de réalisation vérifie l'équation Math 12 à tout instant t de la période T de modulation, période ici égale à $6\Delta\tau$.

Comme dans le premier et le deuxième mode de réalisation, lors de la démodulation du signal de la grandeur à mesurer, par exemple le signal Sagnac, à chaque état de la première demi-période T/2, démodulé pour en extraire la grandeur à mesurer, en + ou en -, correspond un état de même historique, démodulé avec le signe inverse, dans la deuxième demi-période. Ce schéma de démodulation se traduit par l'expression suivante dans le troisième mode de réalisation.

[Math 18]

$$S_S = - P_1 + P_2 + P_3 - P_4 - P_5 + P_6 + P_7 - P_8 - P_9 + P_{10} + P_{11} - P_{12}$$

La démodulation de la fonction de transfert du modulateur de phase, notée $V_\pi$, est effectuée en multipliant les 12 mesures de puissance $P_i$ pour i = 1, ..., 12 acquises sur une période de modulation T, par le signe du produit du signe + ou - de la modulation à $\pm\pi$ et du signe + ou - de la modulation à $\pm$ alpha, indépendamment du signe de la modulation à $\pm$ beta.

Ainsi, la démodulation de la fonction de transfert du modulateur de phase $V_\pi$ modulée sur 12 états s'exprime pour ce troisième mode de réalisation suivant la même équation (Math 16) que pour le deuxième mode de réalisation.

Enfin, la démodulation de la fonction de transfert du système de détection, notée $\Delta$P, est effectuée en multipliant les 12 mesures de puissance $P_i$ pour i = 1, ..., 12 acquises sur la période de modulation T = 6$\Delta\tau$, par le signe du produit du signe + ou - de la modulation à $\pm$ alpha et du signe + ou - de la modulation à $\pm$ beta lorsque beta est non nul et par 0 lorsque beta est nul, indépendamment du signe de la modulation à $\pm$ $\pi$. En particulier, beta est nul pour les états a, b, c et d.

Ainsi, la démodulation de la fonction de transfert du système de détection $\Delta$P sur 12 états s'exprime comme suit dans le troisième mode de réalisation.

[Math 19]

$$S_{\Delta P} = - P_1 + P_2 - P_7 + P_8$$

Dans le troisième mode de réalisation aussi, le signal de la grandeur à mesurer est corrigé des défauts induits par la constante de temps RC du modulateur de phase.

La figure 10 illustre un exemple du troisième mode de réalisation en présence d'un signal de la grandeur à mesurer. Dans l'exemple illustré sur la figure 10, on choisit les valeurs suivantes pour alpha et beta : alpha = 3$\pi$/8 et beta = 3$\pi$/128. RC est égal à $\Delta\tau$/12. La différence de phase induite par la grandeur à mesurer est ici égale à $\Delta\Phi_S$ =3$\pi$/32. La mesure de $\Delta\Phi_S$ est corrigée des défauts induits par la constante de temps RC du modulateur de phase. Par conséquent, la mesure présente une meilleure stabilité.

De façon avantageuse, la modulation sur 8 niveaux et 12 états selon l'un quelconque des modes de réalisation décrits ci-dessus est utilisée pour asservir le signal du paramètre à mesurer (par exemple le signal Sagnac), le réglage du signal $V_\pi$ et/ou la réponse en boucle ouverte (ou signal $\Delta$P).

En résumé, le tableau ci-dessous indique les règles de démodulation pour les trois modes de réalisation décrits ci-dessus.

[Tableaux 1]

| Mod. $\pi$ | Mod. $\pi$ et alpha | Mod. $\pi$ , alpha et beta | Niveaux de modulation | Démodulation paramètre à mesurer | Démodulation $V_\pi$ | Démodulation $\Delta$P |
|---|---|---|---|---|---|---|
| +$\pi$ | +$\pi$+alpha | +$\pi$+alpha+beta | a⁺ | + | + | + |
| | | +$\pi$+alpha | a | + | + | 0 |
| | | +$\pi$+alpha-beta | a⁻ | + | + | - |
| | +$\pi$-alpha | +$\pi$-alpha+beta | b⁺ | - | - | - |
| | | +$\pi$-alpha | b | - | - | 0 |
| | | +$\pi$-alpha-beta | b⁻ | - | - | + |
| -$\pi$ | -$\pi$+alpha | -$\pi$+alpha+beta | c⁺ | + | - | + |
| | | -$\pi$+alpha | c | + | - | 0 |
| | | -$\pi$+alpha-beta | c | + | - | - |
| | -$\pi$-alpha | -$\pi$-alpha+beta | d⁺ | - | + | - |
| | | -$\pi$-alpha | d | - | + | 0 |
| | | -$\pi$-alpha-beta | d | - | + | + |

L'invention s'applique à un interféromètre à fibre optique de Sagnac en boucle pour mesurer une vitesse de rotation autour de l'axe de la bobine de fibre optique, par exemple tel qu'illustré sur la figure 1. Dans l'interféromètre à fibre optique de Sagnac en boucle, la première onde monomode 101 et la seconde onde monomode 102 sont polarisées linéairement et la bobine de fibre optique 17 est à maintien de polarisation linéaire. Le système de traitement du signal 900 applique une tension de modulation 60 sur les électrodes du modulateur optique de phase 16 de manière à générer une modulation de la différence de phase à au moins 8 états et 12 niveaux selon l'un quelconque des modes de réalisation décrit ci-dessus. Le système de traitement du signal 900 applique au signal détecté 80 une démodulation adaptée en fonction de la modulation choisie.

L'invention s'applique également à un interféromètre à fibre optique en boucle ou en ligne pour des applications comme capteur de champ magnétique ou comme capteur de courant électrique.

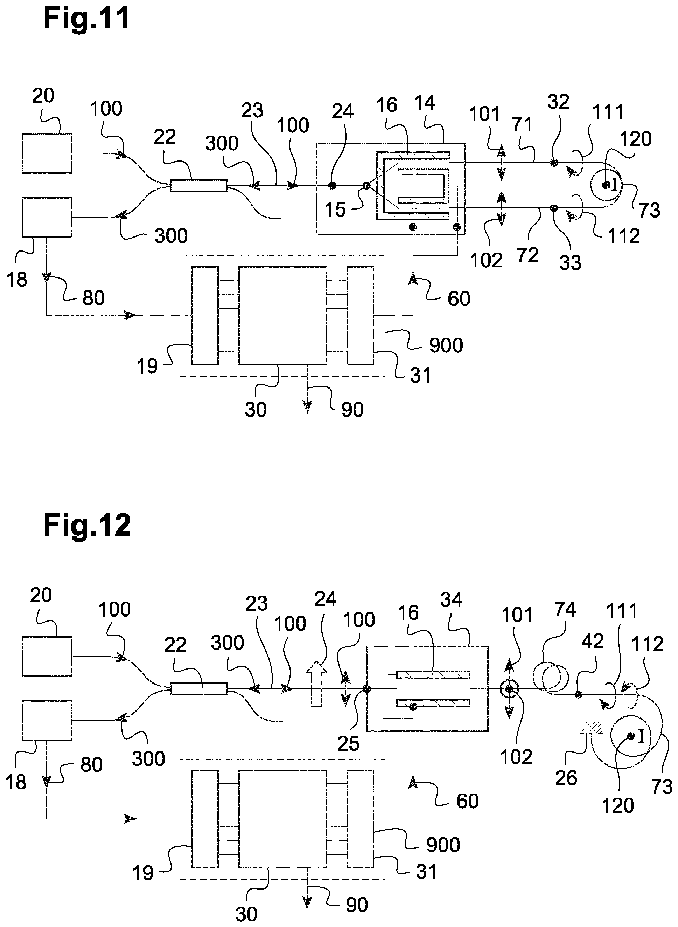

A titre d'exemple non limitatif, la figure 11 représente un interféromètre à fibre optique en boucle destiné à une application comme capteur de courant électrique. Les mêmes signes de référence désignent les mêmes éléments que sur la figure 1. Dans cette application, un ensemble de fibres optiques comporte une section de fibre optique 71, une bobine de fibre optique 73 et une autre section de fibre optique 72 disposées en série. La fibre optique 73 est enroulée autour d'un axe. La fibre optique 73 est de préférence à maintien de polarisation circulaire. La section de fibre optique 71 est de préférence à maintien de polarisation linéaire. L'autre section de fibre optique 72 est aussi de préférence à maintien de polarisation linéaire. Un conducteur électrique 120 est disposé le long de l'axe de la bobine de fibre optique 73. On note I un courant électrique traversant la bobine de fibre optique 73. Le circuit optique intégré 14 est analogue à celui décrit en lien avec la figure 1. En sortie du circuit optique intégré 14, la première onde monomode 101 et la seconde onde monomode 102 sont polarisées linéairement suivant le même état de polarisation. La première onde monomode 101 se propage dans la section de fibre optique 71. La seconde onde monomode 102 se propage dans l'autre section de fibre optique 72. Une lame quart d'onde 32 reçoit la première onde monomode 101 polarisée linéairement et transmet une première onde monomode 111 polarisée circulairement, par exemple circulaire droite, à une extrémité de la bobine de fibre optique 73. Une autre lame quart d'onde 33 reçoit la seconde onde monomode 102 polarisée linéairement et transmet une seconde onde monomode 112 polarisée circulairement, ici par exemple aussi circulaire droite, à l'autre extrémité de la bobine de fibre optique 73. La première onde monomode 111 circulaire droite et la seconde onde monomode 112 circulaire droite se propagent en sens inverse dans la bobine de fibre optique 73. En sortie de la bobine de fibre optique 73, les lames quart d'onde 32, 33 transforment les ondes polarisées circulairement en ondes polarisées linéairement qui se recombinent pour former le faisceau interférométrique 300. Le système de traitement du signal 900 applique l'un quelconque des schémas de modulation-démodulation à au moins 8 états et 12 niveaux pour extraire une mesure de courant électrique corrigée de la constante de temps RC du modulateur de phase. La différence de temps de propagation $\Delta\tau$ à considérer pour la modulation de phase $\Delta\Phi_m(t)$ est alors le temps de propagation dans la fibre optique 73 et dans les sections de fibre 71 et 72.

A titre d'autre exemple non limitatif, la figure 12 représente un interféromètre à fibre optique en ligne destiné à une application comme capteur de courant électrique. Dans cet exemple, un polariseur 24 polarise linéairement le faisceau source 100. Le circuit optique intégré 34 comporte uniquement un guide d'onde formé par exemple par diffusion de titane dans un substrat de niobate de lithium. Les électrodes du modulateur de phase 16 sont déposées le long des côtés du guide d'onde. Le guide d'onde du circuit optique intégré 34 est biréfringent. Les axes optiques du polariseur 24 sont orientés de préférence à 45 degrés des axes de biréfringence du guide d'onde du circuit optique intégré 34 à l'entrée-sortie 25 du circuit optique intégré 34. De cette manière, le polariseur 24 et le circuit optique intégré 34 séparent le faisceau source 100 en polarisation et génèrent la première onde monomode 101 polarisée suivant un état de polarisation linéaire et la seconde onde monomode 102 polarisée suivant l'état de polarisation linéaire orthogonal. Le guide d'onde du circuit optique intégré 34 guide les deux polarisations. Le modulateur de phase 16 ayant une efficacité différente selon la polarisation, il génère bien un différentiel de modulation du déphasage des deux ondes, et va permettre les mêmes modulations de phase que dans la configuration en boucle. Pour ce modulateur différentiel, on parle souvent de modulateur de biréfringence. Dans ce mode de réalisation, l'ensemble de fibres optiques comporte une section de fibre optique 74 et une bobine de fibre optique 73 disposées en série. La fibre optique 73 est enroulée autour d'un axe. La fibre optique 73 est de préférence à conservation de polarisation circulaire. La section de fibre optique 74 est de préférence à maintien de polarisation linéaire. La première onde monomode 101 et la seconde onde monomode 102 se propagent dans la section de fibre optique 74. Une lame quart d'onde 42 reçoit la première onde monomode 101 polarisée linéairement et transmet une première onde monomode polarisée circulairement 111, par exemple circulaire droite, à une extrémité de la bobine de fibre optique 73. La lame quart d'onde 42 reçoit la seconde onde monomode 102 polarisée suivant un autre état de polarisation linéaire orthogonal et transmet une seconde onde monomode polarisée circulairement 112, ici circulaire gauche, à la même extrémité de la bobine de fibre optique 73. Un miroir 26 est disposé à l'autre extrémité de la bobine de fibre optique 73. Après un premier passage dans la bobine de fibre optique 73, les deux ondes monomodes de polarisation circulaires orthogonales 111, 112 se réfléchissent sur le miroir 26. A la réflexion sur le miroir, leurs états de polarisation sont inversés. Les deux ondes monomodes effectuent un deuxième passage en sens inverse, et avec leurs polarisations inversées, dans la bobine de fibre optique 73. La lame quart d'onde 42 reçoit les deux ondes monomodes de polarisations circulaires orthogonales et les transforme en deux ondes de polarisations linéaires orthogonales. Le circuit optique intégré 34 et le polariseur 24 recombinent ces deux ondes et forment le faisceau interférométrique 300. Le système de traitement du signal 900 applique l'un quelconque des schémas de modulation-démodulation à au moins 8 états et 12 niveaux pour extraire une mesure de courant électrique corrigée de la constante de temps RC du modulateur de phase. Dans ce cas, la différence de temps de propagation $\Delta\tau$ à considérer pour la modulation de phase $\Delta\Phi_m(t)$ est le temps de propagation aller-retour dans la section de fibre optique 74 et la bobine de fibre optique 73.

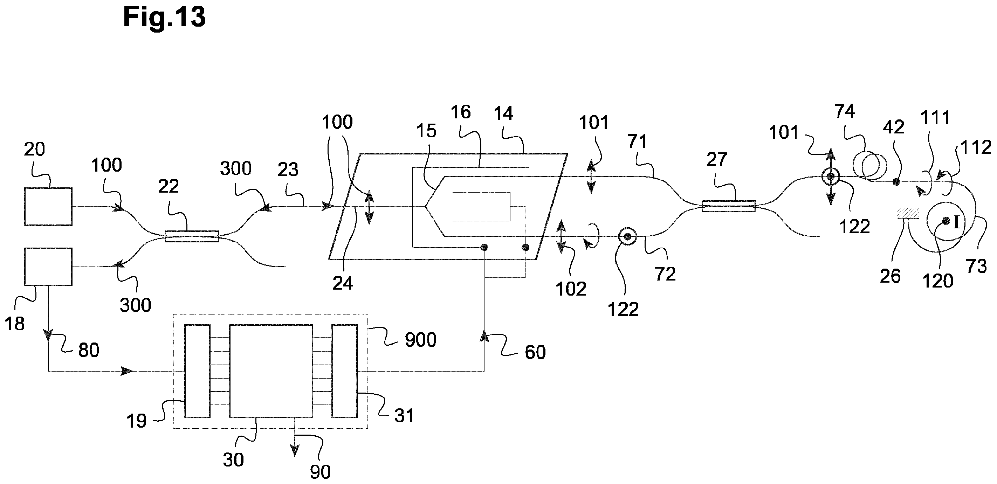

La figure 13 représente un autre exemple d'interféromètre à fibre optique en ligne destiné à une application comme capteur de courant électrique. Dans cet exemple, le circuit optique intégré 14 comprend un guide d'onde 24 polarisant et un séparateur 15, de type à jonction Y, analogue à celui décrit en lien avec les figures 1 et 11. L'ensemble de fibres optiques comporte ici une section de fibre optique 71, une autre section de fibre optique 72, une section de fibre optique 74 et une bobine de fibre optique 73. La fibre optique 73 est enroulée autour d'un axe. La fibre optique 73 est de préférence à maintien de polarisation circulaire. Les sections de fibre optique 71, 72 et 74 sont de préférence à maintien de polarisation linéaire. Le guide d'onde 24 polarise linéairement le faisceau source 100. Le séparateur 15 sépare le faisceau source 100 polarisé linéairement en la première onde monomode 101 polarisée linéairement et la seconde onde monomode 102 polarisée linéairement suivant le même état de polarisation linéaire. La première onde monomode 101 se propage dans la section de fibre optique 71. La seconde onde monomode 102 se propage dans l'autre section de fibre optique 72. L'autre section de fibre optique 72 est orientée de manière à faire tourner de 90 degrés la polarisation linéaire de la seconde onde monomode 102, qui devient ainsi une seconde onde monomode 122 polarisée linéairement avec une polarisation orthogonale à la première onde monomode 101. Un coupleur-séparateur de polarisation 27 recombine la première onde monomode 101 et la seconde onde monomode 122, de polarisations linéaires orthogonales qui se propagent dans la section de fibre optique 74. Une lame quart d'onde 42 transforme les polarisations linéaires orthogonales en polarisations circulaires orthogonales 111, 112. De manière analogue au mode de réalisation décrit en lien avec la figure 12, le miroir 26 réfléchit les deux ondes monomodes 111, 112 et inverse leurs polarisations. De cette manière, les deux ondes monomodes parcourent l'ensemble de fibre optique suivant des états de polarisation inversés. Le système de traitement du signal 900 applique l'un quelconque des schémas de modulation-démodulation à au moins 8 états et 12 niveaux pour extraire une mesure de courant électrique corrigée de la constante de temps RC du modulateur de phase. La différence de temps de propagation $\Delta\tau$ à considérer dans ce cas pour la modulation de phase $\Delta\Phi_m(t)$ est le temps de propagation dans les sections de fibre 71 et 72 et le temps de propagation aller-retour dans la section de fibre 74 et la fibre optique 73.

Bien entendu, diverses autres modifications peuvent être apportées à l'invention dans le cadre des revendications annexées.

## Revendications

**1.** Interféromètre à fibre optique en boucle ou en ligne comprenant une source lumineuse (20) adaptée pour générer un faisceau source (100), un dispositif optique de séparation (15, 24, 34) adapté pour séparer le faisceau source en une première onde monomode (101) et une seconde onde monomode (102), un système électronique (900) adapté pour appliquer une tension électrique de modulation $V_m(t)$ à un modulateur de phase (16) apte à induire un même déphasage $\Phi_m(t)$ sur la première onde monomode et la seconde onde monomode, un ensemble de fibre optique (17, 71, 72, 73, 74) adapté pour recevoir et propager la première onde monomode suivant un premier chemin optique et, respectivement, la seconde onde monomode suivant un second chemin optique inverse du premier chemin optique, et pour former après une différence de temps de propagation $\Delta\tau$, une première onde de sortie et, respectivement, une seconde onde de sortie, ayant une différence de phase modulée $\Delta\Phi_m(t) = \Phi_m(t) - \Phi_m(t-\Delta\tau)$, l'ensemble de fibres optiques (17, 71, 72, 73, 74 ) ayant une fréquence propre $f_p$ égale à l'inverse du double de la différence de temps de propagation $\Delta\tau$, le dispositif optique de séparation (15, 24, 34) étant adapté pour recombiner la première onde de sortie et la seconde onde de sortie et former un faisceau interférométrique (300) modulé temporellement, un système de détection (18) adapté pour détecter une puissance P(t) du faisceau interférométrique (300) en fonction du temps, **caractérisé en ce que** la différence de phase modulée $\Delta\Phi_m(t)$ est égale à la somme d'une première différence de phase périodique $\Delta\Phi_\pi(t)$ de niveau égal à $\pm \pi$, d'une deuxième différence de phase $\Delta\Phi_{alpha}(t)$ périodique de niveau égal à $\pm$alpha et d'une troisième différence de phase $\Delta\Phi_{beta}(t)$ périodique de niveau variable entre -beta et +beta, alpha et beta ayant des valeurs différentes prédéterminées, de manière à ce que la différence de phase modulée $\Delta\Phi_m(t)$ ait une période de modulation T égale à un multiple impair (2M+1) du double de la différence de temps de propagation $\Delta\tau$, où M est un nombre entier naturel, la différence de phase modulée $\Delta\Phi_m(t)$ comportant par période de modulation T au moins huit niveaux de modulation parmi les douze niveaux de modulation suivants: $\Delta\Phi_{a+} = \pi$ + alpha + beta ; $\Delta\Phi_{a-} = \pi$ + alpha - beta ; $\Delta\Phi_a = \pi$ + alpha ; $\Delta\Phi_{b+} = \pi$ - alpha + beta ; $\Delta\Phi_{b-} = \pi$ - alpha - beta ; $\Delta\Phi_b = \pi$ - alpha ; $\Delta\Phi_{c+} = -\pi$ + alpha +beta ; $\Delta\Phi_{c-} = -\pi$ + alpha - beta ; $\Delta\Phi_c = -\pi$ + alpha ; $\Delta\Phi_{d+} = -\pi$ - alpha + beta ; $\Delta\Phi_{d-} = -\pi$ - alpha - beta ; $\Delta\Phi_d = -\pi$ - alpha ; et cette différence de phase modulée étant telle que :

$$\Delta\Phi_m(t + T/2) = -\Delta\Phi_m(t)$$

à chaque instant t compris entre 0 et T.

**2.** Interféromètre à fibre optique en boucle ou en ligne selon la revendication 1 dans lequel la période de modulation T est égale au double de la différence de temps de propagation $\Delta\tau$, la première différence de phase $\Delta\Phi_\pi(t)$ ayant une fréquence de modulation égale à la fréquence propre $f_p$ et dans lequel la deuxième différence de phase $\Delta\Phi_{alpha}(t)$ et la troisième différence de phase $\Delta\Phi_{beta}(t)$ ont une même fréquence de modulation égale à un multiple impair (2N+1) de la fréquence propre $f_p$, où N est un nombre entier naturel non nul, la deuxième différence de phase $\Delta\Phi_{alpha}(t)$ étant synchronisée avec la première différence de phase $\Delta\Phi_\pi(t)$, la troisième différence de phase $\Delta\Phi_{beta}(t)$ étant en quadrature de phase par rapport à la deuxième différence de phase $\Delta\Phi_{alpha}$ (t).

**3.** Interféromètre à fibre optique en boucle ou en ligne selon la revendication 1 dans lequel la période de modulation T est égale au double de la différence de temps de propagation $\Delta\tau$, la troisième différence de phase $\Delta\Phi_{beta}(t)$ ayant une fréquence de modulation égale à la fréquence propre $f_p$, et dans lequel la première différence de phase $\Delta\Phi_\pi(t)$ et la deuxième différence de phase $\Delta\Phi_{alpha}(t)$ ont une même fréquence de modulation égale à un multiple impair (2N+1) de la fréquence propre $f_p$, où N est un nombre entier naturel non nul, la deuxième différence de phase étant en quadrature de phase par rapport à la première différence de phase, la troisième différence de phase $\Delta\Phi_{beta}(t)$ étant synchronisée avec la première différence de phase ou la deuxième différence de phase.

**4.** Interféromètre à fibre optique en boucle ou en ligne selon la revendication 1 dans lequel M est un nombre entier non nul et dans lequel la première différence de phase $\Delta\Phi_\pi(t)$ et la deuxième différence de phase $\Delta\Phi_{alpha}(t)$ ont une même fréquence de modulation égale à la fréquence propre $f_p$, la deuxième différence de phase étant en quadrature de phase par rapport à la première différence de phase et la troisième différence de phase $\Delta\Phi_{beta}(t)$ ayant une période de modulation égale à la période de modulation T, cette troisième différence de phase étant synchronisée avec la première différence de phase ou la deuxième différence de phase.

**5.** Interféromètre à fibre optique en boucle ou en ligne selon l'une des revendications 1 à 4 dans lequel le système de détection (18) comporte un système électronique de démodulation adapté pour extraire un signal représentatif d'une grandeur à mesurer, un signal de fonction de transfert du modulateur de phase et/ou un signal de fonction de transfert du système de détection à partir d'une série d'au moins 12 mesures de puissance du faisceau interférométrique détecté par période de modulation.

**6.** Interféromètre à fibre optique en boucle ou en ligne selon la revendication 5 dans lequel le signal représentatif de la grandeur à mesurer est égal à une somme des mesures de puissance du faisceau interférométrique acquises par période de modulation, chaque mesure de puissance étant multipliée par -1 pour les niveaux correspondant à - alpha et par +1 pour les niveaux correspondant à + alpha.

**7.** Interféromètre à fibre optique en boucle ou en ligne selon la revendication 5 ou 6 dans lequel le signal de fonction de transfert du modulateur de phase est égal à une somme des mesures de puissance du faisceau interférométrique acquises par période de modulation, chaque mesure de puissance étant multipliée par le signe du produit du signe de la première modulation à $\pm\pi$ et du signe + ou - de la deuxième modulation à $\pm$ alpha, ou par zéro de manière à conserver un même nombre d'états multipliés par le signe + et d'états multipliés par le signe -.

**8.** Interféromètre à fibre optique en boucle ou en ligne selon l'une des revendications 5 à 7 dans lequel le signal de fonction de transfert du système de détection est égal à une somme des mesures de puissance du faisceau interférométrique acquises par période de modulation, chaque mesure de puissance étant multipliée par le signe du produit du signe de la deuxième modulation à $\pm$ alpha et du signe de la troisième modulation à $\pm$ beta lorsque le niveau de cette troisième modulation est +beta ou -beta, et par zéro lorsque le niveau de la troisième modulation est nul.

**9.** Interféromètre à fibre optique en boucle ou en ligne selon l'une des revendications 5 à 8 dans lequel la différence de phase modulée $\Delta\Phi_m(t)$ comporte en outre une rampe composée de marches de phase $\Delta\Phi_{FS}$ opposées à une différence de phase $\Delta\Phi_S$ du signal représentatif de la grandeur à mesurer.

**10.** Interféromètre à fibre optique en boucle selon l'une des revendications 1 à 9 dans lequel le dispositif optique de séparation (15) est adapté pour séparer spatialement le faisceau source en la première onde monomode (101) et la seconde onde monomode (102) et dans lequel l'ensemble de fibres optiques (17, 71, 72, 73, 74) comporte une bobine de fibre optique (17, 73) adaptée pour recevoir la première onde monomode à une première extrémité de la bobine de fibre optique et, respectivement, la seconde onde monomode à une seconde extrémité de la bobine de fibre optique, la première onde monomode et la seconde onde monomode se propageant en sens inverse dans la bobine de fibre optique (17, 73).

11. Interféromètre à fibre optique en boucle selon la revendication 10 dans lequel la première onde monomode et la seconde onde monomode sont polarisées linéairement et la bobine de fibre optique (17) est à maintien de polarisation linéaire, l'interféromètre étant adapté pour mesurer une différence de phase représentative d'une rotation autour d'un axe de la bobine de fibre optique (17).

12. Interféromètre à fibre optique en boucle selon la revendication 10 dans lequel l'ensemble de fibres optiques (17, 71, 72, 73, 74) comporte une section de fibre optique (71) à maintien de polarisation linéaire, la bobine de fibre optique (73) à maintien de polarisation circulaire et une autre section de fibre optique (72) à maintien de polarisation linéaire, une lame quart d'onde (32) étant disposée entre la section de fibre optique (71)et une extrémité de la bobine de fibre optique (73), une autre lame quart d'onde (33) étant disposée entre l'autre section de fibre optique (72) et l'autre extrémité de la bobine de fibre optique (73), l'interféromètre étant adapté pour mesurer une différence de phase induite par un courant électrique traversant la bobine de fibre optique (73).

13. Interféromètre à fibre optique en ligne selon l'une des revendications 1 à 9 dans lequel l'ensemble de fibres optiques (17, 71,72, 73, 74) comporte une section de fibre optique (74) à maintien de polarisation linéaire et une bobine de fibre optique (73) à maintien de polarisation circulaire, la section de fibre optique (74) étant reliée à une extrémité de la bobine de fibre optique (73), un miroir (26) étant disposé à une seconde extrémité de la bobine de fibre optique (73), l'interféromètre étant adapté pour mesurer une différence de phase induite par un courant électrique traversant la bobine de fibre optique (73).

14. Interféromètre à fibre optique en boucle ou en ligne selon la revendication 5 seule ou combinée à l'une des revendications 6 à 13, comprenant un système de rétroaction adapté pour asservir la mesure du signal représentatif de la grandeur à mesurer, du signal de fonction de transfert du modulateur de phase et/ou du signal de fonction de transfert du système de détection.


**Patentansprüche**

1. Interferometer mit einer schleifenförmigen oder geraden optischen Faser mit einer zum Erzeugen eines Quellenstrahls (100) ausgelegten Lichtquelle (20), einer zum Trennen des Quellenstrahls in eine erste Monomodewelle (101) und eine zweite Monomodewelle (102) ausgelegten optischen Trennvorrichtung (15, 24, 34), einem elektronischen System (900), das zum Anlegen einer elektrischen Modulationsspannung $V_m(t)$ an einen Phasenmodulator (16) ausgelegt ist, der geeignet ist, auf der ersten Monomodewelle und der zweiten Monomodewelle eine gleiche Phasenverschiebung $\Phi_m(t)$ zu induzieren, einer Gesamtheit optischer Fasern (17, 71, 72, 73, 74), die dazu ausgelegt ist, die erste Monomodewelle auf einem ersten optischen Weg und, entsprechend, die zweite Monomodewelle auf einem zum ersten optischen Weg inversen zweiten optischen Weg zu empfangen und auszubreiten, und um nach einer Ausbreitungszeitdifferenz $\Delta\tau$ eine erste Ausgangswelle und, entsprechend, eine zweite Ausgangswelle zu bilden, die eine modulierte Phasendifferenz $\Delta\Phi_m(t) = \Phi_m(t) - \Phi_m(t-\tau)$ hat, wobei die Gesamtheit optischer Fasern (17, 71, 72, 73, 74) eine Eigenfrequenz $f_p$ gleich dem inversen Zweifachen der Ausbreitungszeitdifferenz $\Delta\tau$ hat, wobei die optische Trennvorrichtung (15, 24, 34) dazu ausgelegt ist, die erste Ausgangswelle und die zweite Ausgangswelle zu rekombinieren und einen zeitlich modulierten interferometrischen Strahl (300) zu bilden, einem Erfassungssystem (18), das dazu ausgelegt ist, eine Leistung P(t) des interferometrischen Strahls (300) in Abhängigkeit von der Zeit zu erfassen, **dadurch gekennzeichnet, daß** die modulierte Phasendifferenz $\Delta\Phi_m(t)$ gleich der Summe einer ersten periodischen Phasendifferenz $\Delta\Phi_\pi(t)$ mit einem Niveau gleich $\pm\pi$, einer zweiten periodischen Phasendifferenz $\Delta\Phi_{alpha}(t)$ mit einem Niveau gleich $\pm$alpha und einer dritten periodischen Phasendifferenz $\Delta\Phi_{beta}(t)$ mit einem variablen Niveau zwischen -beta und +beta ist, wobei alpha und beta unterschiedliche vorbestimmte Werte haben, damit die modulierte Phasendifferenz $\Delta\Phi_m(t)$ eine Modulationsperiode T gleich einem ungeradzahligen Mehrfachen (2M+1) des Zweifachen der Ausbreitungszeitdifferenz $\Delta\tau$ hat, wobei M eine natürliche ganze Zahl ist, wobei die modulierte Phasendifferenz $\Delta\Phi_m(t)$ je Modulationsperiode T mindestens acht Modulationsniveaus der folgenden zwölf Modulationsniveaus hat:

$\Delta\Phi_{a+} = \pi$ + alpha + beta; $\Delta\Phi_{a-} = \pi$ + alpha - beta; $\Delta\Phi_a = \pi$ + alpha; $\Delta\Phi_{b+} = \pi$ - alpha + beta; $\Delta\Phi_{b-} = \pi$ - alpha - beta; $\Delta\Phi_b = \pi$ - alpha; $\Delta\Phi_{c+} = -\pi$ + alpha + beta; $\Delta\Phi_{c-} = -\pi$ + alpha - beta; $\Delta\Phi_c = -\pi$ + alpha; $\Delta\Phi_{d+} = -\pi$ - alpha + beta; $\Delta\Phi_{d-} = -\pi$ - alpha -

beta; $\Delta\Phi_d = -\pi$ - alpha; und wobei diese modulierte Phasendifferenz so ist, daß:

$$\Delta\Phi_m(t + T/2) = \Delta\Phi_m(t)$$

zu jedem Zeitpunkt t zwischen 0 und T ist.

2.  Interferometer mit einer schleifenförmigen oder geraden optischen Faser gemäß Anspruch 1, bei dem die Modulationsperiode T gleich dem Zweifachen der Ausbreitungszeitdifferenz $\Delta\tau$ ist, wobei die erste Phasendifferenz $\Delta\Phi_\pi(t)$ eine Modulationsfrequenz gleich der Eigenfrequenz $f_p$ hat, und bei dem die zweite Phasendifferenz $\Delta\Phi_{alpha}(t)$ und die dritte Phasendifferenz $\Delta\Phi_{beta}(t)$ eine gleiche Modulationsfrequenz gleich einem ungeradzahligen Vielfachen (2N+1) der Eigenfrequenz $f_p$ haben, wobei N eine von Null verschiedene natürliche ganze Zahl ist, wobei die zweite Phasendifferenz $\Delta\Phi_{alpha}(t)$ mit der ersten Phasendifferenz $\Delta\Phi_\pi(t)$ synchronisiert ist, wobei die dritte Phasendifferenz $\Delta\Phi_{beta}(t)$ in Bezug auf die zweite Phasendifferenz $\Delta\Phi_{alpha}(t)$ in Phasenquadratur ist.

3.  Interferometer mit einer schleifenförmigen oder geraden optischen Faser gemäß Anspruch 1, bei dem die Modulationsperiode T gleich dem Zweifachen der Ausbreitungszeitdifferenz $\Delta\tau$ ist, wobei die dritte Phasendifferenz $\Delta\Phi_{beta}(t)$ eine Modulationsfrequenz gleich der Eigenfrequenz $f_p$ hat, und bei dem die erste Phasendifferenz $\Delta\Phi_\pi(t)$ und die zweite Phasendifferenz $\Delta\Phi_{alpha}(t)$ eine gleiche Modulationsfrequenz gleich einem ungeradzahligen Vielfachen (2N+1) der Eigenfrequenz $f_p$ haben, wobei N eine von Null verschiedene natürliche ganze Zahl ist, wobei die zweite Phasendifferenz in Bezug auf die erste Phasendifferenz in Phasenquadratur ist, wobei die dritte Phasendifferenz $\Delta\Phi_{beta}(t)$ mit der ersten Phasendifferenz oder der zweiten Phasendifferenz synchronisiert ist.

4.  Interferometer mit einer schleifenförmigen oder geraden optischen Faser gemäß Anspruch 1, bei dem M eine von Null verschiedene ganze Zahl ist und bei dem die erste Phasendifferenz $\Delta\Phi_\pi(t)$ und die zweite Phasendifferenz $\Delta\Phi_{alpha}(t)$ eine gleiche Modulationsfrequenz gleich der Eigenfrequenz $f_p$ haben, wobei die zweite Phasendifferenz in Bezug auf die erste Phasendifferenz in Phasenquadratur ist und die dritte Phasendifferenz $\Delta\Phi_{beta}(t)$ eine Modulationsperiode gleich der Modulationsperiode T hat, wobei diese dritte Phasendifferenz mit der ersten Phasendifferenz oder der zweiten Phasendifferenz synchronisiert ist.

5.  Interferometer mit einer schleifenförmigen oder geraden optischen Faser gemäß einem der Ansprüche 1 bis 4, bei dem das Erfassungssystem (18) ein elektronisches Demodulationssystem aufweist, das dazu ausgelegt ist, ein für eine zu messende Größe repräsentatives Signal, ein Übertragungsfunktionssignal des Phasenmodulators und/oder ein Übertragungsfunktionssignal des Erfassungssystems aus einer Serie von mindestens 12 Leistungsmessungen des je Modulationsperiode erfaßten interferometrischen Strahls zu entnehmen.

6.  Interferometer mit einer schleifenförmigen oder geraden optischen Faser gemäß Anspruch 5, bei dem das für die zu messende Größe repräsentative Signal gleich einer Summe der während der Modulationsperiode erfaßten Messungen der Leistung des interferometrischen Strahls ist, wobei jede Leistungsmessung für die -alpha entsprechenden Werte mit -1 und für die +alpha entsprechenden Werte mit +1 multipliziert wird.

7.  Interferometer mit einer schleifenförmigen oder geraden optischen Faser gemäß Anspruch 5 oder 6, bei dem das Übertragungsfunktionssignal des Phasenmodulators gleich einer Summe der je Modulationsperiode erfaßten Messungen der Leistung des interferometrischen Strahls ist, wobei jede Leistungsmessung mit dem Vorzeichen des Produkts des Vorzeichens der ersten Modulation mit $\pm\pi$ und des + oder - Vorzeichens der zweiten Modulation mit $\pm$ alpha oder mit Null multipliziert wird, um eine gleiche Anzahl von mit dem Vorzeichen + multiplizierten Zuständen und mit dem Vorzeichen - multiplizierten Zuständen zu behalten.

8.  Interferometer mit einer schleifenförmigen oder geraden optischen Faser gemäß einem der Ansprüche 5 bis 7, bei dem das Übertragungsfunktionssignal des Erfassungssystems gleich einer Summe der je Modulationsperiode erfaßten Messungen der Leistung des interferometrischen Strahls ist, wobei jede Leistungsmessung mit dem Vorzeichen des Produkts des Vorzeichens der zweiten Modulation mit $\pm$alpha und des Vorzeichens der dritten Modulation mit $\pm$beta multipliziert wird, wenn das Niveau der dritten Modulation +beta oder -beta ist, und mit Null, wenn das Niveau der dritten Modulation Null ist.

9.  Interferometer mit einer schleifenförmigen oder geraden optischen Faser gemäß einem der Ansprüche 5 bis 8, bei dem die modulierte Phasendifferenz $\Delta\Phi_m(t)$ außerdem eine Rampe aufweist, die aus Phasenstufen $\Delta\Phi_{FB}$ gebildet ist, die zu einer Phasendifferenz $\Delta\Phi_S$ des für die zu messende Größe repräsentativen Signals entgegengesetzt sind.

10. Interferometer mit einer schleifenförmigen optischen Faser gemäß einem der Ansprüche 1 bis 9, bei dem die Trennvorrichtung (15) dazu ausgelegt ist, den Quellenstrahl räumlich in eine erste Monomodewelle (101) und eine zweite Monomodewelle (102) zu trennen, und bei dem die Gesamtheit der optischen Fasern (17, 71, 72, 73, 74) eine Spule (17, 73) aus einer optischen Faser aufweist, die dazu ausgelegt ist, die erste Monomodewelle an einem ersten Ende der Spule aus einer optischen Faser und, entsprechend, die zweite Monomodewelle an einem zweiten Ende der Spule aus einer optischen Faser zu empfangen, wobei sich die erste Monomodewelle und die zweite Monomodewelle in der Spule (17, 73) aus einer optischen Faser in entgegengesetzter Richtung ausbreiten.

11. Interferometer mit einer schleifenförmigen optischen Faser gemäß Anspruch 10, bei dem die erste Monomodewelle und die zweite Monomodewelle linear polarisiert sind und die Spule (17) aus einer optischen Faser die lineare Polarisation bewahrt, wobei das Interferometer dazu ausgelegt ist, eine für eine Drehung um eine Achse der Spule (17) aus einer optischen Faser repräsentative Phasendifferenz zu messen.

12. Interferometer mit einer schleifenförmigen optischen Faser gemäß Anspruch 10, bei dem die Gesamtheit optischer Fasern (17, 71, 72, 73, 74) einen Abschnitt (71) mit optischer Faser mit Erhalt der linearen Polarisation, die Spule (73) aus einer optischen Faser mit Erhalt der zirkularen Polarisation und einen anderen Abschnitt (72) mit optischer Faser mit Erhalt der linearen Polarisation aufweist, wobei eine Viertelwellenlängeklinge (32) zwischen dem Abschnitt (71) aus einer optischen Faser und einem Ende der Spule (73) aus einer optische Faser angeordnet ist und eine weitere Viertelwellenlängeklinge (33) zwischen dem anderen Abschnitt (72) aus einer optischen Faser und dem anderen Ende der Spule (73) aus einer optischen Faser angeordnet ist, wobei das Interferometer dazu ausgelegt ist, eine durch einen die Spule (73) aus einer optischen Faser durchlaufenden Strom induzierte Phasendifferenz zu messen.

13. Interferometer mit einer geraden optischen Faser gemäß einem der Ansprüche 1 bis 9, bei dem die Gesamtheit optischer Fasern (17, 71, 72, 73, 74) einen Abschnitt (74) mit optischer Faser mit Erhalt der linearen Polarisation und eine Spule (73) aus einer optischen Faser mit Erhalt der zirkularen Polarisation aufweist, wobei der Abschnitt (74) mit optischer Faser mit einem Ende der Spule (73) aus einer optischen Faser verbunden ist, wobei ein Spiegel (26) an einem zweiten Ende der Spule (73) aus einer optischen Faser angeordnet ist, wobei das Interferometer dazu ausgelegt ist, eine durch einen die Spule (73) aus einer optischen Faser durchlaufenden Strom induzierte Phasendifferenz zu messen.

14. Interferometer mit einer schleifenförmigen oder geraden optischen Faser gemäß Anspruch 5 allein oder in Kombination mit einem der Ansprüche 6 bis 13, mit einem Retroaktionssystem, das dazu ausgelegt ist, das Messen des für die zu messende Größe repräsentativen Signals, des Übertragungsfunktionssignals des Phasenmodulators und/oder des Übertragungsfunktionssignals des Erfassungssystems zu steuern.

## Claims

1. A fiber-optic loop or in-line interferometer comprising a light source (20) adapted to generate a source beam (100), an optical splitting device (15, 24, 34) adapted to split the source beam into a first single-mode wave (101) and a second single-mode wave (102), an electronic system (900) adapted to apply a modulation electric voltage $V_m(t)$ to a phase modulator (16) adapted to induce a same phase shift $\Phi_m(t)$ on the first single-mode wave and the second single-mode wave, a optical fiber set (17, 71, 72, 73, 74) adapted to receive and propagate the first single-mode wave along a first optical path and the second single-mode wave along a second optical path, reverse of the first optical path, respectively, and to form after a propagation time difference $\Delta\tau$ a first output wave and a second output wave, respectively, having a modulated phase difference $\Delta\Phi_m(t) = \Phi_m(t) - \Phi_m(t-\Delta\tau)$, the optical fiber set (17, 71, 72, 73, 74) having an eigen frequency $f_p$ equal to the inverse of the double of the propagation time difference $\Delta\tau$, the optical splitting device (15, 24, 34) being adapted to recombine the first output wave and the second output wave and to form a temporally modulated interferometric beam (300), a detection system (18) adapted to detect a power P(t) of the interferometric beam (300) as a function of time, **characterized in that** the modulated phase difference $\Delta\Phi_m(t)$ is equal to the sum of a first periodic phase difference $\Delta\Phi_\pi(t)$ of level equal to $\pm\pi$, a second periodic phase difference $\Delta\Phi_{alpha}(t)$ of level equal to $\pm$alpha and a third periodic phase difference $\Delta\Phi_{beta}(t)$ of variable level between -beta and +beta, alpha and beta having predetermined different values, in such a way that the modulated phase difference $\Delta\Phi_m(t)$ has a period of modulation T equal to an odd multiple (2M+1) of the double of the propagation time difference $\Delta\tau$, where M is a natural integer, the modulated phase difference $\Delta\Phi_m(t)$ having, per period of modulation T, at least eight modulation levels among the twelve following modulation levels: $\Delta\Phi_{a+} = \pi + alpha + beta$; $\Delta\Phi_{a-} = \pi + alpha - beta$; $\Delta\Phi_a = \pi + alpha$; $\Delta\Phi_{b+} = \pi - alpha + beta$; $\Delta\Phi_{b-} = \pi - alpha - beta$; $\Delta\Phi_b = \pi - alpha$; $\Delta\Phi_{c+} = -\pi + alpha + beta$; $\Delta\Phi_{c-} = -\pi + alpha - beta$; $\Delta\Phi_c = -\pi + alpha$; $\Delta\Phi_{d+} = -\pi - alpha + beta$; $\Delta\Phi_{d-} = -\pi - alpha - beta$; $\Delta\Phi_d = -\pi - alpha$; and this modulated phase difference being such that:

$$\Delta\Phi_m(t + T/2) = -\Delta\Phi_m(t)$$

at each time t comprised between 0 and T.

2. The fiber-optic loop or in-line interferometer according to claim 1, wherein the period of modulation T is equal to the double of the propagation time difference $\Delta\tau$, the first phase difference $\Delta\Phi_\pi(t)$ has a modulation frequency equal to the eigen frequency $f_p$ and wherein the second phase difference $\Delta\Phi_{alpha}(t)$ and the third phase difference $\Delta\Phi_{beta}(t)$ have a same modulation frequency equal to an odd multiple (2N+1) of the eigen frequency $f_p$, where N is a non-zero natural integer, the second phase difference $\Delta\Phi_{alpha}(t)$ being synchronized with the first phase difference $\Delta\Phi_\pi(t)$, the third phase difference $\Delta\Phi_{beta}(t)$ being in phase quadrature with respect to the second phase difference $\Delta\Phi_{alpha}(t)$.

3. The fiber-optic loop or in-line interferometer according to claim 1, wherein the period of modulation T is equal to the double of the propagation time difference $\Delta\tau$, the third phase difference $\Delta\Phi_{beta}(t)$ having a modulation frequency equal to the eigen frequency $f_p$ and wherein the first phase difference $\Delta\Phi_\pi(t)$ and the second phase difference $\Delta\Phi_{alpha}(t)$ have a same modulation frequency equal to an odd multiple (2N+1) of the eigen frequency $f_p$, where N is a non-zero natural integer, the second phase difference being in phase quadrature with respect to the first phase difference, the third phase difference $\Delta\Phi_{beta}(t)$ being synchronized with the first phase difference or with the second phase difference.

4. The fiber-optic loop or in-line interferometer according to claim 1, wherein M is a non-zero integer and wherein the first phase difference $\Delta\Phi_\pi(t)$ and the second phase difference $\Delta\Phi_{alpha}(t)$ have a same modulation frequency equal to the eigen frequency $f_p$, the second phase difference being in phase quadrature with respect to the first phase difference and the third phase difference $\Delta\Phi_{beta}(t)$ having a period of modulation equal to the period of modulation T, this third phase difference being synchronized with the first phase difference or the second phase difference.

5. The fiber-optic loop or in-line interferometer according to any one of claims 1 to 4, wherein the detection system (18) includes an electronic demodulation system adapted to extract a signal representative of a quantity to be measured, a transfer function signal of the phase modulator and/or a transfer function signal of the detection system from a series of at least 12 power measurements of the detected interferometric beam per period of modulation.

6. The fiber-optic loop or in-line interferometer according to claim 5, wherein the signal representative of the quantity to be measured is equal to a sum of the interferometric beam power measurements acquired per period of modulation, each power measurement being multiplied by -1 for the levels corresponding to -alpha and by +1 for the levels corresponding to +alpha.

7. The fiber-optic loop or in-line interferometer according to claim 5 or 6, wherein the transfer function signal of the phase modulator is equal to a sum of the interferometric beam power measurements acquired per period of modulation, each power measurement being multiplied by the sign of the product of the first $\pm\pi$ modulation sign and the second $\pm$alpha modulation + or - sign, or by zero in such a way as to keep a same number of states multiplied by the sign + and states multiplied by the sign -.

8. The fiber-optic loop or in-line interferometer according to any one of claims 5 to 7, wherein the transfer function signal of the detection system is equal to a sum of the interferometric beam power measurements acquired per period of modulation, each power measurement being multiplied by the sign of the product of the second $\pm$alpha modulation sign and the third $\pm$beta modulation sign when the level of this last modulation is +beta or -beta, and by zero when the level of this third beta modulation is zero.

9. The fiber-optic loop or in-line interferometer according to any one of claims 5 to 8, wherein the modulated phase difference $\Delta\Phi_m(t)$ further includes a ramp composed of phase steps $\Delta\Phi_{FB}$ opposite to a phase difference $\Delta\Phi_S$ of the signal representative of the quantity to be measured.

10. A fiber-optic loop interferometer according to any one of claims 1 to 9, wherein the optical splitting device (15) is adapted to spatially split the source beam into the first single-mode wave (101) and the second single-mode wave (102) and wherein the optical fiber set (17, 71, 72, 73, 74) includes an optical fiber coil (17, 73) adapted to receive the first single-mode wave at a first end of the optical fiber coil and the second single-mode wave at a second end of the optical fiber coil, respectively, the first single-mode wave and the second single-mode wave propagating in reverse direction in the optical fiber coil (17, 73).

11. The fiber-optic loop interferometer according to claim 10, wherein the first single-mode wave and the second single mode-wave are linearly polarized and the optical fiber coil (17) is of the linear polarization maintaining type, the interferometer being adapted to measure a phase difference representative of a rotation about an axis of the optical fiber coil (17).

12. The fiber-optic loop interferometer according to claim 10, wherein the optical fiber set (17, 71, 72, 73, 74) includes a linear polarization maintaining optical fiber section (71), the circular polarization maintaining optic fiber coil (73) and another linear polarization maintaining optical fiber section (72), a quarter-wave plate (32) being arranged between the optical fiber section (71) and an end of the optical fiber coil (73), another quarter-wave plate being arranged between the other optical fiber section (72) and the other end of the optical fiber coil (73), the interferometer being adapted to measure a phase difference induced by an electric current passing through the optical fiber coil (73).

13. A fiber-optic in-line interferometer according to any one of claims 1 to 9, wherein the optical fiber set (17, 71, 72, 73, 74) includes a linear polarization maintaining optical fiber section (74) and a circular polarization maintaining optic fiber coil (73), the optical fiber section (74) being connected to one end of the optical fiber coil (73), a mirror (26) being arranged at a second end of the optical fiber coil (73), the interferometer being adapted to measure a phase difference induced by an electric current running through the optical fiber coil (73).

14. A fiber-optic loop or in-line interferometer according to claim 5 alone or combined to one of claims 6 to 13, comprising a feedback system adapted to control the measurement of the signal representative of the quantity to be measured, of the modulator transfer function signal and/or of the detection system transfer function signal.

# Fig.1
Art ant.

# Fig.2
Art ant.

**Fig.3** Art ant.

**Fig.4** Art ant.

# Fig.5 Art ant.

# Fig.6

# Fig.7

# Fig.8

Fig.9

Fig.10

**Fig.11**

**Fig.12**

Fig.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2654827 A1

- EP 2005113 B1

**Littérature non-brevet citée dans la description**

- **H. C. LEFÈVRE**. The Fiber-Optic Gyroscope. Artech House, 2014
- **J. BLAKE et al.** In-Line Sagnac Interferometer Current Sensor. *IEEE Transactions on Power Delivery*, 1996, vol. 11 (1), 116-121

- **G.M. MULLER et al.** nherent temperature compensation of fiber-optic current sensors employing spun highly birefringent fiber. *Optics Express*, 2016, vol. 24 (10)